# EUROPEAN PATENT APPLICATION

(11) **EP 4 482 273 A1**
(43) Date of publication of application: **25.12.2024**
(21) Application number: 24159113.0
(22) Date of filing: 22.02.2024
(51) Int. Cl.: H10B 43/20, H10B 43/27, H10B 43/50

(54) **SEMICONDUCTOR DEVICE AND ELECTRONIC SYSTEM INCLUDING THE SAME**

(30) Priority: 22.06.2023 KR 20230080435
(71) Applicant: Samsung Electronics Co., Ltd., Suwon-si, Gyeonggi-do 16677 (KR)
(72) Inventor: KIM, Jihyeon, 16677 Suwon-si, Gyeonggi-do (KR); KWON, Donghoon, 16677 Suwon-si, Gyeonggi-do (KR)
(74) Representative: Kuhnen & Wacker Patent- und Rechtsanwaltsbüro PartG mbB

(57) **Abstract**

A semiconductor device according to an embodiment includes: a gate stacking structure (120) that comprises a first stacking structure (120a) and a second stacking structure (120b) on the first stacking structure (120a), the first stacking structure (120a) and the second stacking structure (120b) each comprising a plurality of gate electrodes (130); a channel structure (CH) that extends into the gate stacking structure (120); and a plurality of gate contact portions (184) that are respectively connected to the plurality of gate electrodes (130) of a first pad area (PA1) of the first stacking structure (120a) and a second pad area (PA2) of the second stacking structure (120b); where the first stacking structure (120a) comprises a buffer insulating portion (132p) that comprises a boundary portion (120p) that is adjacent to the second pad area (PA2), where the buffer insulating portion (132p) comprises a first section (SS1), a second section (SS2), and an inner section (IS) that is between the first section (SS1) and the second section (SS2) in a first direction (Y).

## Description

### TECHNICAL FIELD

The present disclosure relates to a semiconductor device and an electronic system including the same.

### BACKGROUND

In an electron system implementing a data storage, a semiconductor device may be capable of storing high-capacity data. Accordingly, a method for increasing a data storage capacity of a semiconductor device is being researched. As one method for increasing the data storage capacity of a semiconductor device, a semiconductor device including three-dimensionally arranged memory cells instead of two-dimensionally arranged memory cells has been proposed.

### SUMMARY

Embodiments of the present disclosure provide a semiconductor device and an electronic system including the same capable of improving reliability and performance. Embodiments of the invention are set out in the appended claims.

A semiconductor device according to an embodiment includes: a gate stacking structure that comprises a first stacking structure and a second stacking structure on the first stacking structure, the first stacking structure and the second stacking structure each comprising a plurality of gate electrodes; a channel structure that extends into the gate stacking structure; and a plurality of gate contact portions that are respectively connected to the plurality of gate electrodes of a first pad area of the first stacking structure and a second pad area of the second stacking structure; where the first stacking structure comprises a buffer insulating portion that comprises a boundary portion that is adjacent to the second pad area, where the buffer insulating portion comprises a first section, a second section, and an inner section that is between the first section and the second section in a first direction, a length of an upper portion of each of the first section and the second section in the first direction is greater than a length of a lower portion of each of the first section and the second section, respectively, and a first length difference between the length of the upper portion of the first section and the length of the lower portion of the first section is less than a second length difference between the length of the upper portion of the second section and the length of the lower portion of the second section.

In some embodiments, at least one of the first pad area and the second pad area comprises a pad section that respectively connects the plurality of gate electrodes and the plurality of gate contact portions and an upper section at an upper portion of the pad section. A first distance between a gate electrode of the plurality of gate electrodes and the inner section and a second distance between the gate electrode and the inner section are greater than a third distance. The first distance is in the first section, and the second distance is in the second section. The third distance is between the upper section and the gate electrode or between an inner section of the upper section and the gate electrode.

In some embodiments, when a distance between surfaces of adjacent gate electrodes among the plurality of gate electrodes is referred to as a reference thickness and a change amount in length of the upper section, the first section, or the second section in the first direction with respect to the reference thickness is referred to as a reference length change amount, each of the reference length change amount in the first section and the reference length change amount in the second section is greater than the reference length change amount at one side of the upper section.

An electronic system according to an embodiment includes: a main substrate; the semiconductor device on the main substrate; and a controller electrically connected to the semiconductor device on the main substrate.

According to the embodiment, a problem in which a gate electrode is damaged due to falling out or misalignment of a gate contact portion may be fundamentally prevented by a buffer insulating portion provided in a lower structure. In this case, a side surface section of the buffer insulating portion may have a gentle slope so that it is possible to prevent a defect such as a gap in the buffer insulating portion near a corner of the buffer insulating portion. This may improve reliability and performance of a semiconductor device. The buffer insulating portion may have a shape corresponding to a pad insulating portion provided in at least a portion of a pad area or a shape symmetrical to the shape so that it is formed by an easy process.

### BRIEF DESCRIPTION OF THE DRAWINGS

FIG. 1 is a partial plan view showing a semiconductor device according to an embodiment of the present disclosure.
FIG. 2 is a partial cross-sectional view of the semiconductor device taken along cut lines A-A', B-B', and C-C' of FIG. 1.
FIG. 3 is a partial cross-sectional view illustrating an example of a channel structure included in the semiconductor device illustrated in FIG. 1.
FIG. 4 is a schematic partial cross-sectional view of the semiconductor device taken along a cut line D-D' of FIG. 1.
FIG. 5 is a partial plan view illustrating an upper surface of a second stacking structure in the semiconductor device illustrated in FIG. 1.
FIG. 6 is an enlarged view of a portion that corresponds to a portion A of FIG. 4 but does not include a gate contact portion.
FIGS. 7A, 7B, 7C, 7D, 7E, 7F, 7G, 7H, and 7I are partial cross-sectional views illustrating a method for manufacturing the semiconductor device according to an embodiment of the present disclosure.
FIG. 8 is a partial cross-sectional view schematically showing a semiconductor device according to another embodiment of the present disclosure.
FIG. 9 is a partial cross-sectional view schematically showing a semiconductor device according to another embodiment of the present disclosure.
FIG. 10 is an enlarged view of a portion of the semiconductor device shown in FIG. 9.
FIG. 11 is a partial cross-sectional view schematically showing a semiconductor device according to another embodiment of the present disclosure.
FIG. 12 is a partial cross-sectional view schematically showing a semiconductor device according to another embodiment of the present disclosure.
FIG. 13 is a partial cross-sectional view schematically showing a semiconductor device according to an additional embodiment of the present disclosure.
FIG. 14 is a view schematically illustrating an electronic system including the semiconductor device according to an embodiment of the present disclosure.
FIG. 15 is a schematic perspective view of an electronic system including the semiconductor device according to an embodiment of the present disclosure.
FIG. 16 is a schematic cross-sectional view of a semiconductor package according to an embodiment of the present disclosure.
FIG. 17 is a schematic cross-sectional view of a semiconductor package according to an embodiment of the present disclosure.

### DETAILED DESCRIPTION

Embodiments of the present disclosure will be described more fully hereinafter with reference to the accompanying drawings for those skilled in the art to which the present disclosure pertains to easily practice the present disclosure. The present disclosure may be implemented in various different forms and is not limited to the embodiment provided herein.

A portion unrelated to the description is omitted in order to clearly describe the present disclosure, and the same or similar components are denoted by the same reference numeral throughout the present specification.

Further, since sizes and thicknesses of portions, regions, members, units, layers, films, etc. shown in the accompanying drawings may be arbitrarily shown for better understanding and convenience of explanation, the present disclosure is not limited to the illustrated sizes and thicknesses. In the drawings, thicknesses of portions, regions, members, units, layers, films, etc. may be enlarged or exaggerated for convenience of explanation.

It will be understood that when a component such as a layer, film, region, or substrate is referred to as being "on" another component, it may be directly on another component or an intervening component may also be present. In contrast, when a component is referred to as being "directly on" another component, there is no intervening component present. Further, when a component is referred to as being "on" or "above" a reference component, a component may be positioned on or below the reference component, and does not necessarily be "on" or "above" the reference component toward an opposite direction of gravity.

In addition, unless explicitly described to the contrary, the word "comprise", "include", or "contain", and variations such as "comprises", "comprising", "includes", "including", "contains" or "containing" will be understood to imply the inclusion of another component rather than the exclusion of any other components.

Further, throughout the specification, a phrase "on a plane", "in a plane", "on a plan view", or "in a plan view" may indicate a case where a portion is viewed from above or a top portion, and a phrase "on a cross-section" or "in a cross-section" may indicate when a cross-section taken along a vertical direction is viewed from a side.

As used herein, the phrase "at least one of A, B, and C" refers to a logical (A OR B OR C) using a non-exclusive logical OR, and should not be construed to mean "at least one of A, at least one of B and at least one of C." As used herein, the singular forms "a," "an" and "the" are intended to include the plural forms as well, unless the context clearly indicates otherwise. The term "and/or" includes any and all combinations of one or more of the associated listed items. As used herein, "an element A is at a same level as element B" refers to at least one surface of element A that is coplanar with at least one surface of element B. The term "connected" may be used herein to refer to a physical and/or electrical connection and may refer to a direct or indirect physical and/or electrical connection.

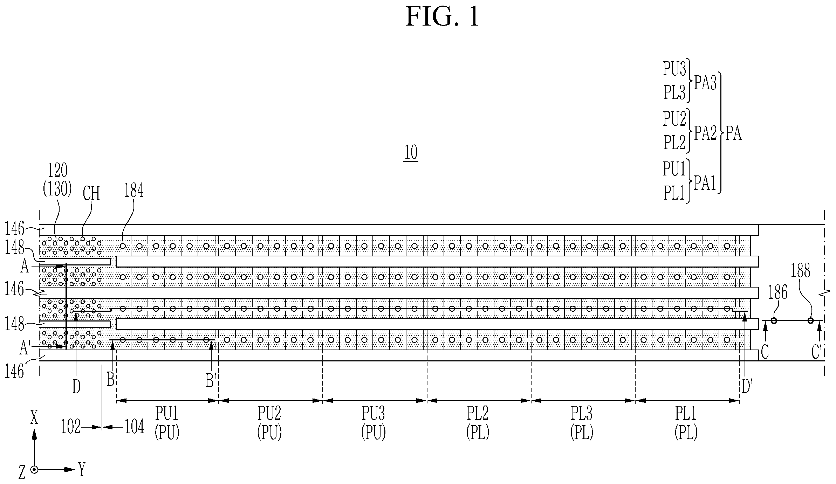

Hereinafter, a semiconductor device and a manufacturing method thereof according to an embodiment will be described in detail with reference to FIGS. 1 to 6 and 7A to 7I.

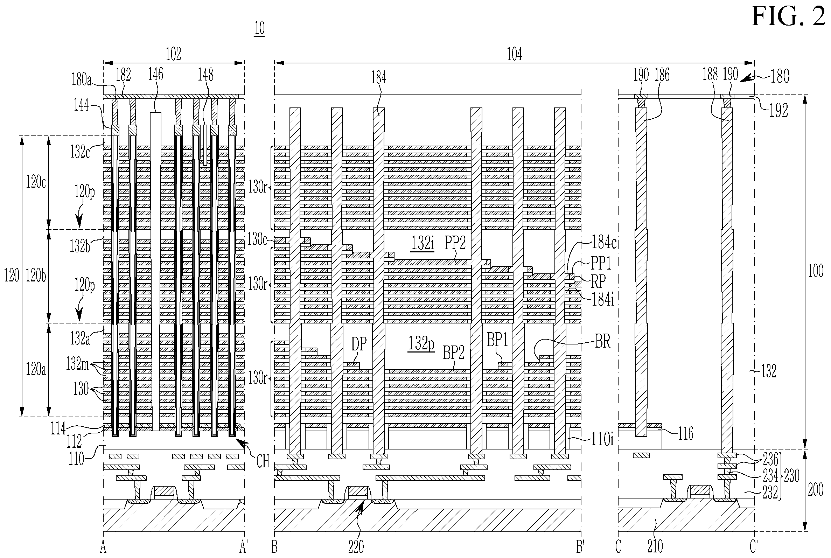

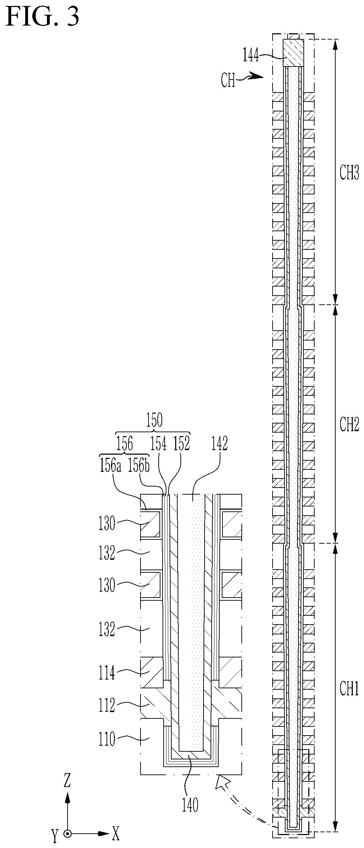

FIG. 1 is a partial plan view showing a semiconductor device according to an embodiment, and FIG. 2 is a partial cross-sectional view of the semiconductor device taken along cut lines A-A', B-B', and C-C' of FIG. 1. FIG. 3 is a partial cross-sectional view illustrating an example of a channel structure included in the semiconductor device illustrated in FIG. 1.

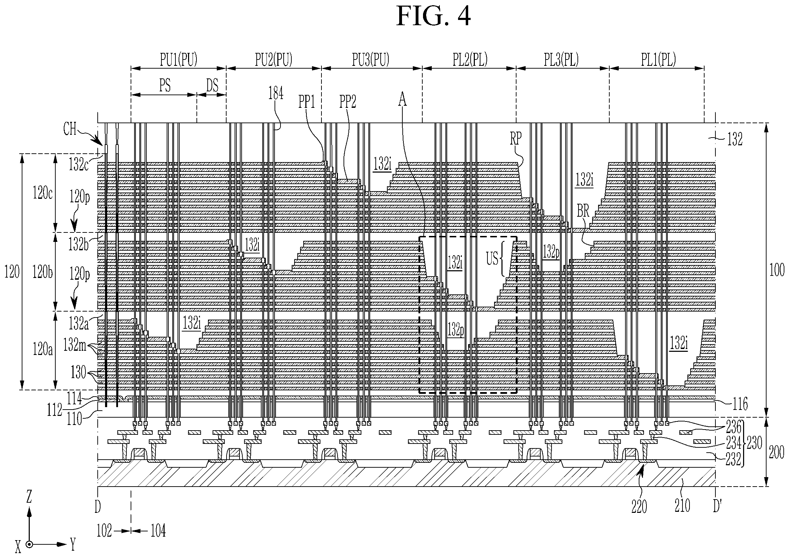

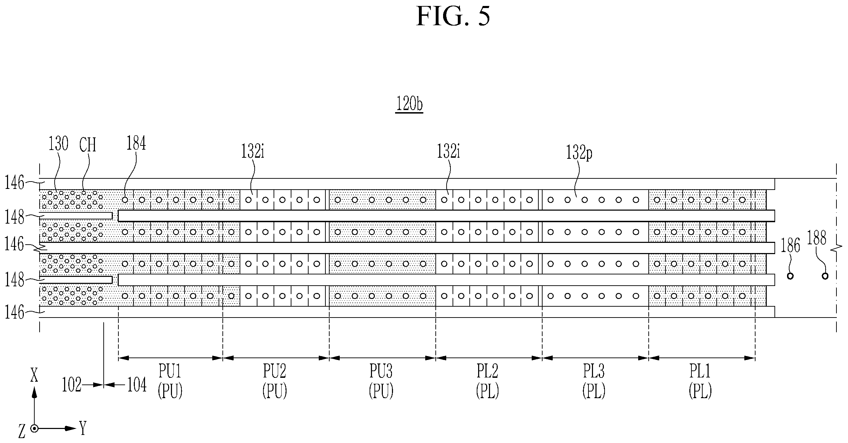

For simplicity and clear understanding, in FIG. 1, a second wire portion 180 is omitted and a channel structure CH, a gate contact portion 184, and the like are mainly shown. Two continuous dotted lines or solid lines in FIG. 1 may refer to a dummy section DS of FIG. 4 of each pad area PA. For simplicity of illustration, in FIG. 1 and FIG. 5 corresponding to FIG. 1, intervals between a plurality of gate contact portions 184 are shown to be the same.

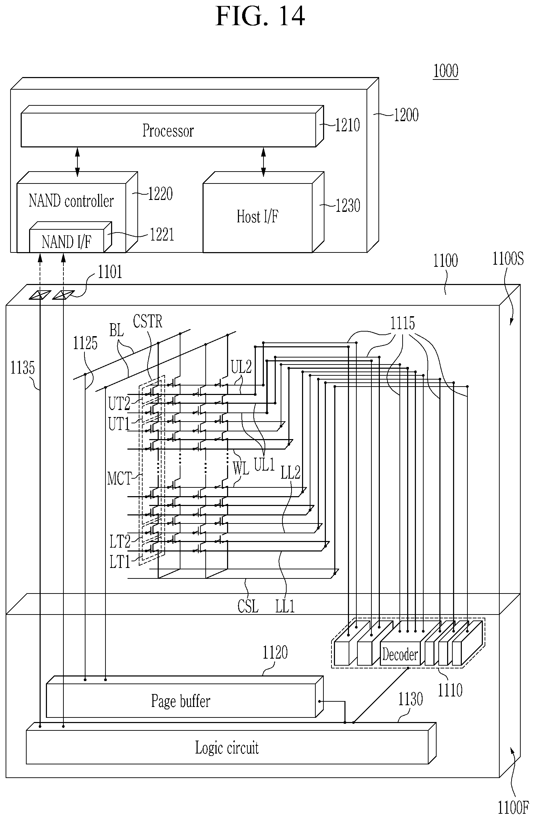

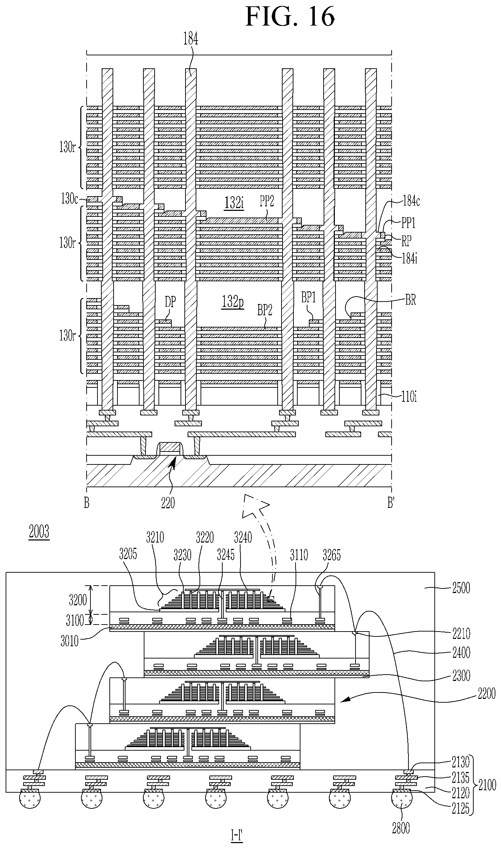

Referring to FIGS. 1 to 3, the semiconductor device 10 according to an embodiment may include a cell region 100 provided with a memory cell structure and a circuit region 200 provided with a peripheral circuit structure controlling an operation of the memory cell structure. For example, the circuit region 200 and the cell region 100 may be portions corresponding to a first structure 1100F and a second structure 1100S of a semiconductor device 1100 included in an electronic system 1000 shown in FIG. 14, respectively. Alternatively, the circuit region 200 and the cell region 100 may be portions including a first structure 3100 and a second structure 3200 of a semiconductor chip 2200 shown in FIG. 16, respectively.

Here, the circuit region 200 may include the peripheral circuit structure formed above or on a first substrate 210, and the cell region 100 may include a gate stacking structure 120 and the channel structure CH formed above or on a cell array region 102 of a second substrate 110 that are the memory cell structure. A first wire portion 230 may be provided in the circuit region 200, and the second wire portion 180 electrically connected to the memory cell structure may be provided in the cell region 100.

In an embodiment, the cell region 100 may be disposed above or on the circuit region 200. Accordingly, since an area corresponding to the circuit region 200 does not need to be secured separately from the cell region 100, an area of the semiconductor device 10 may be reduced. However, the embodiment is not limited thereto, and the circuit region 200 may be disposed next to the cell region 100. Numerous other variations are possible.

The circuit region 200 may include the first substrate 210, and a circuit element 220 and the first wire portion 230 formed above or on the first substrate 210.

The first substrate 210 may be a semiconductor substrate including a semiconductor material. For example, the first substrate 210 may be a semiconductor substrate made of a semiconductor material or may be a semiconductor substrate in which a semiconductor layer is formed on a base substrate. For example, the first substrate 210 may include monocrystalline or polycrystalline silicon, an epitaxial silicon, germanium, silicon-germanium, a silicon on insulator (SOI), a germanium on insulator (GOI), or the like.

The circuit element 220 formed on the first substrate 210 may include various circuit elements that control an operation of the memory cell structure provided in the cell region 100. For example, the circuit element 220 may include peripheral circuit structures such as a decoder circuit 1110 of FIG. 14, a page buffer 1120 of FIG. 14, a logic circuit 1130 of FIG. 14, and the like.

For example, the circuit element 220 may include a transistor, but the present disclosure is not limited thereto. For example, the circuit element 220 may include not only an active element, such as the transistor or the like, but also a passive element, such as a capacitor, a resistor, an inductor, or the like.

The first wire portion 230 disposed above or on the first substrate 210 may be electrically connected to the circuit element 220. In an embodiment, the first wire portion 230 may include a plurality of wire layers 236 that are spaced apart from each other by a first insulating layer 232 disposed between the wire layers and form a desired path by a contact via 234. The wire layer 236 or the contact via 234 may include various conductive materials, and the first insulating layer 232 may include various insulating materials. For example, the wire layer 236 among the plurality of wire layers 236 disposed at an uppermost portion adjacent to the cell region 100 may include a pad portion at which the gate contact portion 184, a through plug 188, and the like are connected, or may constitute a pad portion.

The cell region 100 may include the cell array region 102 and a connection region 104. The gate stacking structure 120 and the channel structure CH may be formed above or on the second substrate 110 in the cell array region 102. A structure that connects the gate stacking structure 120 and/or the channel structure CH formed in the cell array region 102 to the circuit region 200 or an external circuit may be disposed in the cell array region 102 and/or the connection region 104.

In an embodiment, the second substrate 110 may include a semiconductor layer including a semiconductor material. For example, the second substrate 110 may be a semiconductor substrate made of a semiconductor material or may be a semiconductor substrate in which a semiconductor layer is formed on a base substrate. For example, the second substrate 110 may be formed of silicon, germanium, silicon-germanium, a silicon on insulator, a germanium on insulator, or the like. Here, a semiconductor layer included in the second substrate 110 may be doped with p-type or n-type impurities. For example, the semiconductor layer included in the second substrate 110 may be doped with an n-type impurity (e.g., phosphorus (P), arsenic (As), or the like). A substrate insulating portion 110i may be provided in a region through which the gate contact portion 184 passes in the second substrate 110. However, the embodiment is not limited to the material of the second substrate 110, a conductive type of an impurity doped in the semiconductor layer, the material of the semiconductor layer, and the like.

The gate stacking structure 120 including a cell insulating layer 132 and a gate electrode 130 alternately stacked on a first surface (e.g., a front surface or an upper surface) of the second substrate 110 and the channel structure CH extending in a direction crossing the second substrate 110 through the gate stacking structure 120 may be formed at the cell array region 102.

In an embodiment, horizontal conductive layers 112 and 114 may be provided between the second substrate 110 and the gate stacking structure 120 in the cell array region 102. The horizontal conductive layers 112 and 114 may electrically connect the channel structure CH and the second substrate 110. For example, the horizontal conductive layers 112 and 114 may include a first horizontal conductive layer 112 disposed on the first surface of the second substrate 110, and may further include a second horizontal conductive layer 114 disposed on the first horizontal conductive layer 112. The first horizontal conductive layer 112 may not be provided and a horizontal insulating layer 116 may be provided between the second substrate 110 and the gate stacking structure 120 in a partial region of the connection region 104. In a manufacturing process, a portion of the horizontal insulating layer 116 may be replaced with the first horizontal conductive layer 112, and another portion of the horizontal insulating layer 116 disposed at the connection region 104 may remain at the connection region 104.

The first horizontal conductive layer 112 may function as a portion of a common source line of the semiconductor device 10. For example, the first horizontal conductive layer 112 may function as the common source line together with the second substrate 110. As shown in an enlarged view of FIG. 3, the channel structure CH may extend into or penetrate the horizontal conductive layers 112 and 114 to extend to reach the second substrate 110, and a gate dielectric layer 150 may be removed from a portion where the first horizontal conductive layer 112 is disposed so that the first horizontal conductive layer 112 is directly connected to a channel layer 140 around the channel layer 140.

The first and second horizontal conductive layers 112 and 114 may include a semiconductor material (e.g., polycrystalline silicon). For example, the first horizontal conductive layer 112 may be a polycrystalline silicon layer doped with an impurity, and the second horizontal conductive layer 114 may be a polycrystalline silicon layer doped with an impurity or may be a layer including an impurity diffused from the first horizontal conductive layer 112. However, the embodiment is not limited thereto, and the second horizontal conductive layer 114 may be formed of an insulating material. Alternatively, the second horizontal conductive layer 114 may not be provided separately.

The gate stacking structure 120 in which the cell insulating layer 132 and the gate electrodes 130 are alternately stacked may be disposed above or on the second substrate 110 (e.g., on the first and second horizontal conductive layers 112 and 114 formed on the second substrate 110).

In the gate stacking structure 120, the gate electrode 130 may include a lower gate electrode, a memory cell gate electrode, and an upper gate electrode sequentially disposed above the second substrate 110. The lower gate electrode may be used as a gate electrode of a ground selection transistor, the memory cell gate electrode may constitute a memory cell, and the upper gate electrode may be used as a gate electrode of a string selection transistor. The number of memory cell gate electrodes may be determined according to a data storage capacity of the semiconductor device 10. According to an embodiment, one or two or more lower gate electrodes and one or two or more upper gate electrodes may be provided, and each of the lower gate electrode and the upper gate electrode may have the same structure as or a different structure from the memory cell gate electrode. Further, a portion (e.g., the memory cell gate electrode adjacent to the lower gate electrode and the upper gate electrode) of the gate electrode 130 may be a dummy gate electrode.

The cell insulating layer 132 may include an interlayer insulating layer 132m disposed between two adjacent gate electrodes 130 in a plurality of gate stacking structures 120a, 120b, and 120c, and upper insulating layers 132a, 132b, and 132c disposed at an upper portion of the plurality of gate stacking structures 120a, 120b, and 120c. In addition, the cell insulating layer 132 may further include a pad insulating portion 132i formed while filling a recess portion RP provided in the pad area PA and a buffer insulating portion 132p formed while filling a buffer recess portion BR. The pad insulating portion 132i and/or the buffer insulating portion 132p may form a portion of the upper insulating layers 132a, 132b, and 132c. Alternatively, the pad insulating portion 132i and/or the buffer insulating portion 132p may be provided separately from the upper insulating layers 132a, 132b, and 132c.

In an embodiment, thicknesses of a plurality of cell insulating layers 132 may not all be the same. For example, thicknesses of the upper insulating layers 132a, 132b, and 132c may be greater than a thickness of the interlayer insulating layer 132m. For simplicity of illustration, the drawings illustrate that the cell insulating layer 132 is provided as one without a boundary in the connection region 104. However, in the connection region 104, one or a plurality of insulating layers may have various stacking structures. A shape, a structure, or the like of the cell insulating layer 132 may be variously modified according to an embodiment.

The gate electrode 130 may include various conductive materials. For example, the gate electrode 130 may include a metal material, such as tungsten (W), copper (Cu), aluminum (Al), or the like, polycrystalline silicon, metal nitride (e.g., titanium nitride (TiN), tantalum nitride (TaN), or the like), or a combination thereof. As shown in the enlarged view of FIG. 3, a portion (e.g., a first blocking layer 156a) of a blocking layer 156 formed of an insulating material may be disposed outside the gate electrode 130. The cell insulating layer 132 may include various insulating materials. For example, the cell insulating layer 132 may include silicon oxide, silicon nitride, silicon oxynitride, a low dielectric constant material having a lower dielectric constant than the silicon oxide, or a combination thereof.

In an embodiment, the channel structure CH that extends into or penetrates the gate stacking structure 120 and extends in a direction (e.g., a vertical direction perpendicular to the second substrate 110 or a Z-axis direction in the drawings) crossing the second substrate 110 may be formed.

The channel structure CH may include the channel layer 140 and the gate dielectric layer 150 disposed on the channel layer 140 between the gate electrode 130 and the channel layer 140. The channel structure CH may further include a core insulating layer 142 disposed inside the channel layer 140, but in another example, the core insulating layer 142 may not be provided. The channel structure CH may further include the channel layer 140 and/or a channel pad 144 disposed on the gate dielectric layer 150. The gate dielectric layer 150 disposed between the gate electrode 130 and the channel layer 140 may include a tunneling layer 152, a charge storage layer 154, and the blocking layer 156 sequentially formed on the channel layer 140.

Each channel structure CH may form one memory cell string, and a plurality of channel structures CH may be spaced apart from each other while forming rows and columns on a plane. For example, the plurality of channel structures CH may be disposed in various shapes, such as a lattice shape, a zigzag shape, and the like on a plane. The channel structure CH may have a pillar shape. For example, when the channel structure CH is viewed in a cross-section, the channel structure CH may have an inclined side surface so that a width of the channel structure becomes narrow as the channel structure approaches the second substrate 110 according to an aspect ratio. However, the embodiment is not limited thereto, and an arrangement, a structure, a shape, or the like of the channel structure CH may be variously modified.

For example, the channel layer 140 may include a semiconductor material (e.g., polycrystalline silicon). The core insulating layer 142 may include various insulating materials. For example, the core insulating layer 142 may include silicon oxide, silicon nitride, silicon oxynitride, or a combination thereof.

The tunneling layer 152 may include an insulating material (e.g., silicon oxide, silicon nitride, or the like) capable of tunneling a charge. The charge storage layer 154 may be used as a data storage region, and the charge storage layer 154 may include polycrystalline silicon, silicon nitride, or the like. The blocking layer 156 may include an insulating material capable of preventing an undesirable flow of charge into the gate electrode 130. For example, the blocking layer 156 may include silicon oxide, silicon nitride, silicon oxynitride, a high dielectric constant material having a higher dielectric constant than silicon oxide, or a combination thereof. In an embodiment, the blocking layer 156 may include the first blocking layer 156a including a portion extending horizontally along the gate electrode 130 and a second blocking layer 156b extending vertically between the first blocking layer 156a and the charge storage layer 154.

However, a material, a stacking structure, and the like of the channel layer 140, the core insulating layer 142, and the gate dielectric layer 150 may be variously modified, and the embodiment is not limited thereto.

The channel pad 144 may be disposed to cover or overlap an upper surface of the core insulating layer 142 and to be electrically connected to the channel layer 140. For example, the channel pad 144 may include a conductive material (e.g., polycrystalline silicon doped with an impurity), but the present disclosure is not limited thereto.

In an embodiment, the gate stacking structure 120 may include a plurality of gate stacking structures 120a, 120b, and 120c sequentially stacked above the second substrate 110. Then, since the number of stacked gate electrodes 130 may be increased, the number of memory cells with a stable structure may be increased. FIG. 2 illustrates that the gate stacking structure 120 includes the first to third stacking structures 120a, 120b, and 120c. However, the embodiment is not limited thereto, and the gate stacking structure 120 may include two or four or more gate stacking structures.

Thus, when the plurality of gate stacking structures 120a, 120b, and 120c are provided, the channel structure CH may include a plurality of channel structures CH1, CH2, and CH3 respectively extending into or penetrating the plurality of gate stacking structures 120a, 120b, and 120c. The plurality of channel structures CH1, CH2, and CH3 may have a shape connected to each other. When the plurality of channel structures CH1, CH2, and CH3 are viewed in a cross-section, each of the channel structures CH1, CH2, and CH3 may have an inclined side surface so that a width of each of the channel structures becomes narrow as each of the channel structures approaches the second substrate 110 according to an aspect ratio, and a bent portion may be provided by a difference in widths of the channel structures at a portion where the plurality of channel structures CH1, CH2, and CH3 are connected. As another example, the plurality of channel structures CH1, CH2, and CH3 may have an inclined side surface continuously connected without a bent portion. FIG. 3 illustrates that the gate dielectric layer 150, the channel layer 140, and the core insulating layer 142 of the plurality of channel structures CH1, CH2, and CH3 have an integral structure extending from each other. However, the embodiment is not limited thereto, and the gate dielectric layer 150, the channel layer 140, and the core insulating layer 142 of the plurality of channel structures CH1, CH2, and CH3 may be separately formed to be physically or electrically connected to each other. Additionally, a separate channel pad may be additionally provided at a connection portion of the plurality of channel structures CH1, CH2, and CH3. Thus, the embodiment is not limited to shapes of the plurality of channel structures CH1, CH2, and CH3.

In an embodiment, the gate stacking structure 120 may be divided into a plurality of portions on a plane by a separation structure 146 extending in a direction (e.g., a vertical direction perpendicular to the second substrate 110 or a Z-axis direction in the drawings) crossing the second substrate to pass through the gate stacking structure 120. Additionally, an upper separation region 148 may be formed at an upper portion of the gate stacking structure 120. On a plane, the separation structure 146 and/or the upper separation region 148 may extend in a first direction (a Y-axis direction in the drawings), and a plurality of separation structures 146 and/or a plurality of upper separation regions 148 may be provided to be spaced apart from each other at predetermined intervals in a second direction (an X-axis direction in the drawings) crossing the first direction.

By the separation structure 146, on the plane, the plurality of gate stacking structures 120 may extend in the first direction (the Y-axis direction in the drawings), and may be spaced apart from each other at predetermined intervals in the second direction (the X-axis direction in the drawings). The gate stacking structure 120 divided by the separation structure 146 may constitute one memory cell block. However, the embodiment is not limited thereto, and a range of the memory cell block is not limited thereto.

For example, the separation structure 146 may pass through the gate stacking structure 120 to extend to the second substrate 110, and the upper separation region 148 may separate one or a portion of a plurality of gate electrodes 130 from each other. The upper separation region 148 may be disposed between the separation structures 146.

For example, when the separation structure 146 is viewed in a cross-section, the separation structure 146 may have an inclined side surface so that a width of the separation structure 146 is gradually reduced while the separation structure faces the second substrate 110 due to a high aspect ratio, but the embodiment is not limited thereto. A side surface of the separation structure 146 may be perpendicular to the second substrate 110, or may include a bent portion at a connection portion of the plurality of stacking structures 120a, 120b, and 120c.

The separation structure 146 or the upper separation region 148 may be filled with various insulating materials. For example, the separation structure 146 or the upper separation region 148 may include an insulating material, such as silicon oxide, silicon nitride, or silicon oxynitride. However, the embodiment is not limited thereto, and a structure, a shape, a material, or the like of the separation structure 146 or the upper separation region 148 may be variously modified.

The connection region 104 and the second wire portion 180 may be provided to connect the gate stacking structure 120 and the channel structure CH provided in the cell array region 102 to the circuit region 200 or an external circuit. The connection region 104 may be disposed around the cell array region 102, and a portion of the second wire portion 180 may be disposed at the connection region 104.

Here, the second wire portion 180 may include a member electrically connecting the gate electrode 130, the channel structure CH, the horizontal conductive layers 112 and 114, and/or the second substrate 110 to the circuit region 200 or the external circuit. For example, the second wire portion 180 may include a bit line 182, the gate contact portion 184, a source contact portion 186, the through plug 188, a contact via 180a connected to each of the bit line 182, the gate contact portion 184, the source contact portion 186, and the through plug 188, and a connection wire 190 connecting the bit line 182, the gate contact portion 184, the source contact portion 186, and the through plug 188.

The bit line 182 may be disposed above or on the cell insulating layer 132 of the gate stacking structure 120 formed in the cell array region 102. The bit line 182 may extend in a crossing direction (the X-axis direction in the drawings) crossing one direction in which the gate electrode 130 extends. The bit line 182 may be electrically connected to the channel structure CH (e.g., the channel pad 144) through the contact via 180a (e.g., a bit line contact via).

In an embodiment, the gate electrode 130 and the interlayer insulating layer 132m of the plurality of stacking structures 120a, 120b, and 120c may extend in the first direction (the Y-axis direction in the drawings) to be disposed at the connection region 104. Additionally, a plurality of pad areas PA to which the gate contact portion 184 and the gate electrode 130 are connected may be provided in the connection region 104.

The recess portion RP from which the gate electrode 130 is removed may be provided in the pad area PA, so that each of pad portions PP1 and PP2 of a plurality of connection gate electrodes 130c is exposed to an upper portion thereof. The pad portions PP1 and PP2 may be disposed at an end portion of the connection gate electrode 130c and relatively further away from the cell array region 102, and may have a greater thickness than another portion. The recess portion RP of the pad area PA may be filled with the pad insulating portion 132i.

The drawings illustrate that the plurality of pad portions PP1 and PP2 provided within one pad area PA include the first pad portion PP1 having a relatively short length and the second pad portion PP2 having a relatively long length. The second pad portion PP2 may be formed based on an arrangement of the first wire portion 230, a manufacturing process of the semiconductor device 10, or the like. The second pad portion PP2 may be periodically disposed between a plurality of first pad portions PP1, but the embodiment is not limited thereto.

In each pad area PA, the gate contact portion 184 may be electrically connected to the connection gate electrode 130c including the pad portions PP1 and PP2 among the plurality of gate electrodes 130 included in the gate stacking structure 120, and may be insulated by being disposed between a remaining gate electrode 130r and an insulating pattern 184i.

For example, the gate contact portion 184 may pass through the pad portions PP1 and PP2 of the connection gate electrode 130c, and may be connected to inner side surfaces of the pad portions PP1 and PP2. For example, the gate contact portion 184 may protrude toward the inner side surfaces of the pad portions PP1 and PP2 to include a connection portion 184c directly contacting the pad portions PP1 and PP2. A width of the insulating pattern 184i in a horizontal direction may be greater than a thickness of the remaining gate electrode 130r in a vertical or thickness direction. Accordingly, the remaining gate electrode 130r and the gate contact portion 184 may be effectively insulated, but the embodiment is not limited thereto.

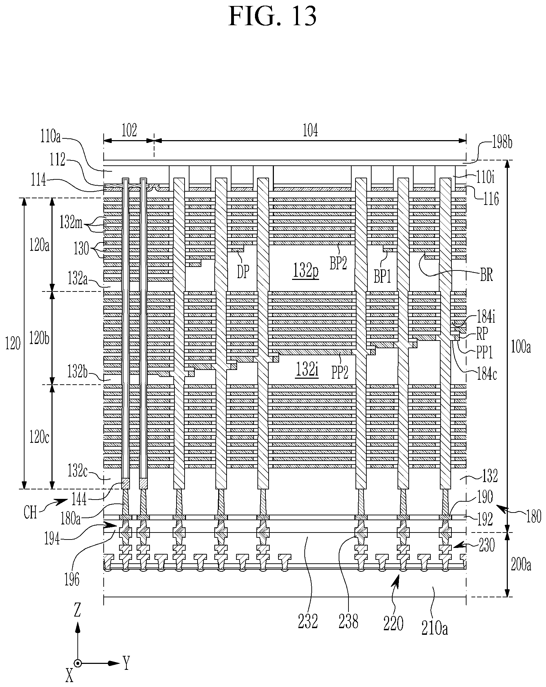

The gate contact portion 184 may pass through the gate stacking structure 120 and the like to extend to a pad portion provided at an uppermost portion of the plurality of wire layers 236 of the circuit region 200 to be connected to the pad portion. Accordingly, the gate contact portion 184 may be connected to the circuit region 200 without passing through the connection wire 190 or the like so that design freedom of the second wire portion 180 is improved. However, a connection method between the gate contact portion 184 and the circuit region 200 may be variously modified. As another example, as shown in FIG. 13, the gate contact portion 184 may be connected to a circuit region 200a of FIG. 13 through the connection wire 190 and a second bonding structure (or a second junction structure) 194. This will be described in detail later with reference to FIG. 13.

For example, the gate contact portion 184 may include a conductive material, such as tungsten (W), copper (Cu), aluminum (Al), or the like, and may further include a diffusion prevention layer. However, the embodiment is not limited to the material of the gate contact portion 184.

In the connection region 104, the source contact portion 186 may extend into or penetrate the cell insulating layer 132 to be electrically connected to the horizontal conductive layers 112 and 114 and/or the second substrate 110, and the through plug 188 may pass through the gate stacking structure 120 or may be disposed outside the gate stacking structure 120 to be electrically connected to the first wire portion 230 of the circuit region 200.

A dummy structure (not shown) may be further provided in the connection region 104. The dummy structure may reduce stress that may be applied to the gate stacking structure 120. The dummy structure may have the same or similar structure or shape as the channel structure CH, but is not electrically connected to the bit line 182. The dummy structure may be formed in the same process as the channel structure CH together with the channel structure CH to be formed of the same structure, shape, material, or the like, or may be formed in a process separate from the channel structure CH to have a different structure, shape, material, or the like from the channel structure CH. In an embodiment, the dummy structure may have a larger plane size than the channel structure CH. However, the embodiment is not limited thereto, and a shape, a position, an arrangement, the number, or the like of the dummy structure may be variously modified.

The connection wire 190 may be disposed at the cell array region 102 and/or the connection region 104. The bit line 182, the source contact portion 186, and/or the through plug 188 may be electrically connected to the connection wire 190. For example, the source contact portion 186 and/or the through plug 188 may be connected to the connection wire 190 through the contact via 180a. In an embodiment, since the contact via 180a and the connection wire 190 connected to the gate contact portion 184 are not provided, design freedom of the second wire portion 180 may be improved. According to an embodiment, the contact via 180a and the connection wire 190 connected to the gate contact portion 184 may be provided.

FIG. 1 illustrates that the connection wire 190 is provided as a single layer disposed on the same plane as the bit line 182 and a second insulating layer 192 is disposed at a portion other than the second wire portion 180. However, this is merely shown for convenience. Therefore, in order for the connection wire 190 to make electrical connection with the bit line 182, the gate contact portion 184, the source contact portion 186, and/or the through plug 188, the connection wire 190 may include a plurality of wire layers, and may further include a contact via.

Thus, the bit line 182, the gate electrode 130, the horizontal conductive layers 112 and 114, and/or the second substrate 110 connected to the channel structure CH may be electrically connected to the circuit element 220 of the circuit region 200 by the second wire portion 180 and the first wire portion 230.

FIG. 2 illustrates that each of the gate contact portion 184, the source contact portion 186, and/or the through plug 188 has an inclined side surface so that a width of each of the gate contact portion 184, the source contact portion 186, and/or the through plug 188 becomes narrow as each of the gate contact portion 184, the source contact portion 186, and/or the through plug 188 approaches the second substrate 110 according to an aspect ratio when each of the gate contact portion 184, the source contact portion 186, and/or the through plug 188 is viewed in a cross-section and the bent portion is provided at a boundary portion 120p of the plurality of gate stacking structures 120a, 120b, and 120c. However, the embodiment is not limited thereto. It is also possible that the source contact portion 186 and/or the through plug 188 do not include the bent portion at the boundary portion 120p of the plurality of stacking structures 120a, 120b, and 120c. Numerous other variations are possible.

In the present embodiment, the buffer insulating portion 132p may be provided adjacent to the boundary portion 120p of the plurality of stacking structures 120a, 120b, and 120c, so that a problem caused by falling out or misalignment of the gate contact portion 184 that may occur at the boundary portion 120p may be prevented. The pad area PA, the pad insulating portion 132i formed at the pad area PA, and the buffer insulating portion 132p will be described in more detail with reference to FIGS. 4 to 6 together with FIGS. 1 and 2.

FIG. 4 is a schematic partial cross-sectional view of the semiconductor device 10 taken along a cut line D-D' of FIG. 1. FIG. 5 is a partial plan view illustrating an upper surface of a second stacking structure 120b in the semiconductor device 10 illustrated in FIG. 1. For simplicity and clarity of understanding, in FIG. 4, the second wire portion 180 is omitted and a shape of the gate contact portion 184 is schematically illustrated. FIG. 5 mainly shows the channel structure CH, the gate contact portion 184, and the like to correspond to FIG. 1, and shows an upper portion surface of the gate electrode 130 disposed at an uppermost portion.

Referring to FIGS. 1, 2, 4, and 5, in an embodiment, the plurality of pad areas PA may be provided to electrically connect the plurality of gate electrodes 130 included in the plurality of stacking structures 120a, 120b, and 120c to the plurality of gate contact portions 184. Here, the plurality of pad areas PA may include a first pad area PA1 where the gate electrode 130 of the first stacking structure 120a is connected to the gate contact portion 184, a second pad area PA2 where the gate electrode 130 of the second stacking structure 120b is connected to the gate contact portion 184, and a third pad area PA3 where the gate electrode 130 of the third stacking structure 120c is connected to the gate contact portion 184.

In this case, each of the first to third pad areas PA1, PA2, and PA3 may include an upper pad area PU where the gate electrode 130 disposed at an upper portion of the plurality of stacking structures 120a, 120b, and 120c is connected to the gate contact portion 184 and a lower pad area PL where the gate electrode 130 disposed at a lower portion of the plurality of stacking structures 120a, 120b, and 120c is connected to the gate contact portion 184.

Thus, if the upper pad area PU and the lower pad area PL are separately provided, a process of forming the pad area PA may be simplified. However, the embodiment is not limited thereto, and the number of the pad areas PA provided in each of the gate stacking structures 120a, 120b, and 120c may be one or three or more.

FIG. 4 illustrates that a first upper pad area PU1, a second upper pad area PU2, a third upper pad area PU3, a second lower pad area PL2, a third lower pad area PL3, and a first lower pad area PL1 are sequentially disposed in a direction away from the cell array region 102. However, this is presented as an example and the embodiment is not limited thereto.

The upper pad area PU may include a pad section PS and the dummy section DS. Additionally, the lower pad area PL may include a pad section PS, a dummy section DS, and an upper section US. Here, the pad section PS may be disposed at one side of the pad area PA and may be a section where the plurality of gate electrodes 130 and the plurality of gate contact portions 184 are connected, and the dummy section DS may be a section disposed at the other side of the pad area PA. Additionally, the upper section US may be portions disposed at upper portions of the pad section PS and the dummy section DS.

More specifically, in the pad section PS, the plurality of gate electrodes 130 may be sequentially removed by the recess portion RP. In an embodiment, in the pad section PS, lengths of the plurality of gate electrodes 130 may be sequentially increased while the lengths of the plurality of gate electrodes 130 extend in a direction away from the cell array region 102. For example, in the pad section PS, the plurality of gate electrodes 130 may have a stair shape that descends downward in a direction away from the cell array region 102. In this case, the plurality of gate electrodes 130 may have a stair shape in one direction or in a plurality of directions. Accordingly, in the pad section PS, the plurality of pad portions PP1 and PP2 of the plurality of connection gate electrodes 130c may have a shape in which each of the plurality of pad portions PP1 and PP2 is exposed upward.

In the dummy section DS, the plurality of gate electrodes 130 may be sequentially removed by the recess portion RP. In an embodiment, in the dummy section DS, lengths of the plurality of gate electrodes 130 may be sequentially increased while the lengths of the plurality of gate electrodes 130 extend downward in a direction toward the cell array region 102. For example, in the dummy section DS, the plurality of gate electrodes 130 may have a stair shape that descends downward in a direction toward the cell array region 102. The stair shape of the plurality of gate electrodes 130 in the dummy section DS may have a steeper slope than the stair shape of the plurality of gate electrodes 130 in the pad section PS, but the embodiment is not limited thereto.

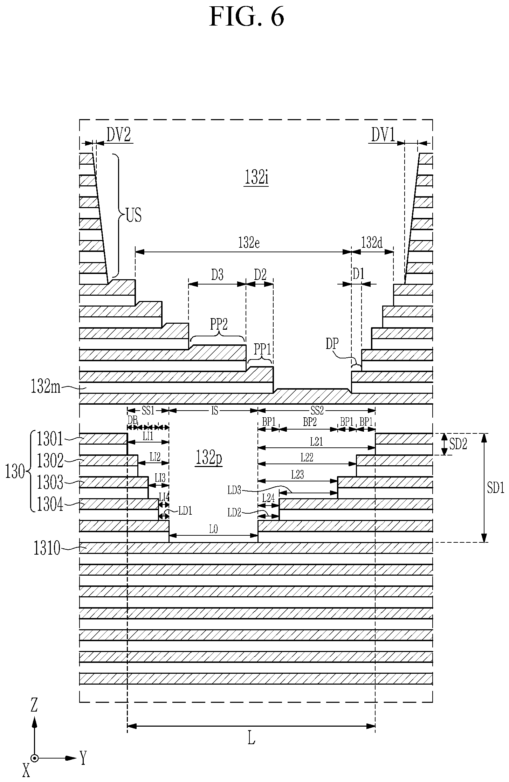

Accordingly, the pad insulating portion 132i provided in the dummy section DS may include a plurality of dummy portions DP that are disposed at surfaces (upper portion surfaces of FIG. 3) of the plurality of gate electrodes 130 in the first direction (the Y-axis direction in the drawings), have dummy lengths D1 of FIG. 6, and are sequentially disposed in the first direction. The pad insulating portion 132i provided in the pad section PS may be disposed at surfaces (upper portion surfaces of FIG. 6) of the plurality of gate electrodes 130 in the first direction, and may include a plurality of portions. Here, the plurality of portions may include a first portion having a first bottom length D2 of FIG. 6 and a second portion having a second bottom length D3 of FIG. 6 greater than the first bottom length D2.

In the upper section US, the plurality of gate electrodes 130 may be removed by the recess portion RP. In an embodiment, each side of the upper section US may include a vertical surface perpendicular to the second substrate 110 or the first direction, or an inclined surface that is inclined to the second substrate 110 or the first direction that decreases in length from an upper portion thereof to a lower portion thereof. In this case, the inclined surface may have a steep slope. Here, the length may refer to a length in the first direction (the Y-axis direction in the drawings). This may prevent an entire length of the upper pad area PU from increasing due to the upper section US. However, the embodiment is not limited thereto.

The recess portion RP of the pad area PA described above may have a shape or profile for sequentially exposing the plurality of pad portions PP1 and PP2 of the plurality of connection gate electrodes 130c in each pad area PA. The shape or profile of the recess portion RP or the gate electrode 130 in the pad section PS, the dummy section DS, and/or the upper section US of each pad area PA may be the same or similar.

The pad insulating portion 132i may include an insulating material filled in the recess portion RP from which the plurality of gate electrodes 130 are removed from each pad area PA.

In an embodiment, the buffer insulating portion 132p may be formed at a portion of a lower structure adjacent to the boundary portion 120p. A separate insulating structure is further provided in consideration of possible falling out or misalignment of the gate contact portion 184 at a portion adjacent to the boundary portion 120p. Accordingly, an insulating structure of the gate contact portion 184 may be stably implemented at the boundary portion 120p.

A gate stacking structure disposed at a lower portion of one boundary portion 120p may be referred to as a lower structure, and a gate stacking structure disposed at an upper portion of the one boundary portion 120p may be referred to as an upper structure. In the first and second gate stacking structures 120a and 120b, the first stacking structure 120a may be a lower structure and the second stacking structure 120b may be an upper structure. In the second and third gate stacking structures 120b and 120c, the second stacking structure 120b may be a lower structure and the third stacking structure 120c may be an upper structure. In each pad area PA, a gate stacking structure including the connection gate electrode 130c may be referred to as a connection structure, and a gate stacking structure not including the connection gate electrode 130c may be referred to as an insulating structure.

When the upper structure is the connection structure and the lower structure is the insulating structure, the buffer insulating portion 132p may include the boundary portion 120p of the lower structure to be formed at the lower structure. The buffer insulating portion 132p may include an insulating material filled in the buffer recess portion BR from which one or the plurality of gate electrodes 130 provided in the lower structure are removed.

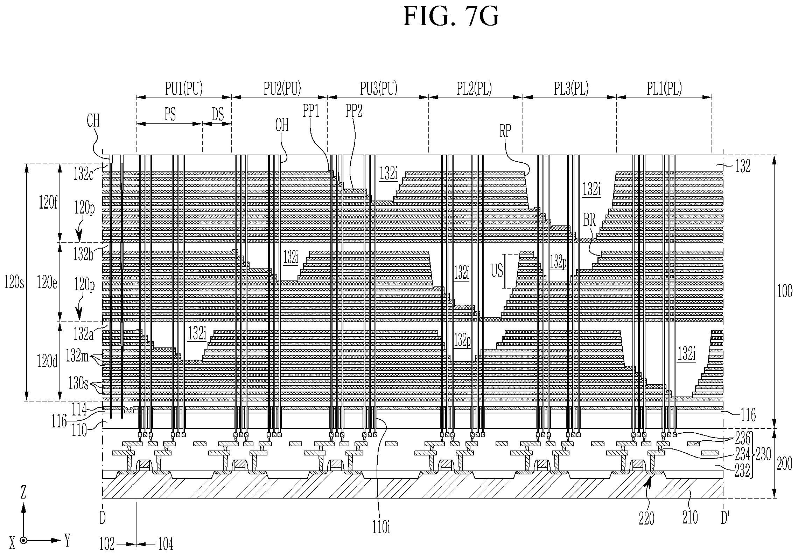

In an embodiment, an etching process may be performed on the gate stacking structure 120 and/or the pad insulating portion 132i to form a wire penetrating portion OH of FIG. 7G for forming the gate contact portion 184. There is a difference in etching speed or etching type in the etching process between a portion where the gate stacking structure 120 is disposed and a portion where the pad insulating portion 132i is disposed. For example, the etching speed at the portion where the pad insulating portion 132i is disposed may be greater than the etching speed at the portion where the gate stacking structure 120 is disposed, so that an area or a size of the wire penetrating portion OH is increased at the portion where the pad insulating portion 132i is disposed. In other words, when the upper structure is the connection structure, the wire penetrating portion OH may have a relatively large area or size at the boundary portion 120p of the lower structure so that the gate contact portion 184 formed at the upper structure at the boundary portion 120p of the lower structure also has a large area or size. Accordingly, a possibility of a problem occurring due to falling out or misalignment of the gate contact portion 184 at the boundary portion 120p may increase. As such, the buffer insulating portion 132p may be formed at a region including the boundary portion 120p in the lower structure disposed at a lower portion of the connection structure.

FIG. 5 illustrates that the gate electrode 130 is entirely removed in the second direction (the X-axis direction in the drawings) or a width direction in the lower structure disposed at the lower portion of the connection structure and the buffer insulating portion 132p is formed at the removed portion. In other words, FIG. 5 illustrates that the buffer insulating portion 132p is entirely formed in the second direction or the width direction. Accordingly, falling out or misalignment of the gate contact portion 184 may be effectively prevented. However, the embodiment is not limited thereto. As another example, FIG. 5 illustrates that the gate electrode 130 is partially removed in the second direction (the X-axis direction in the drawings) or the width direction in the lower structure disposed at the lower portion of the connection structure and the buffer insulating portion 132p is formed at the removed portion. That is, the buffer insulating portion 132p may be partially formed in the second direction or the width direction. Accordingly, an electrical connection path may be maintained as it is at a portion where the buffer insulating portion 132p is disposed. Therefore, the buffer insulating portion 132p may be formed at various positions regardless of an arrangement or the like of the plurality of pad areas PA. Numerous other variations are possible.

The buffer insulating portion 132p may be made of the same insulating material as the pad insulating portion 132i. Alternatively, the buffer insulating portion 132p may include silicon oxide, silicon nitride, silicon oxynitride, a low dielectric constant material having a lower dielectric constant than the silicon oxide, or a combination thereof. However, the embodiment is not limited thereto. For example, the buffer insulating portion 132p may be made of a different material from that of the pad insulating portion 132i, or may include an insulating material different from the above-described material.

A shape of the buffer insulating portion 132p will be described in more detail with reference to FIG. 6. FIG. 6 is an enlarged view of a portion that corresponds to a portion A of FIG. 4 but does not include the gate contact portion 184.

Referring to FIG. 4 and FIG. 6, in an embodiment, the buffer insulating portion 132p may include an inner section IS, a first section SS1 disposed at one side of the inner section IS, and a second section SS2 disposed at the other side of the inner section IS. In this case, each of the first section SS1 and the second section SS2 may have a longer length in the first direction (the Y-axis direction in the drawings) at an upper portion thereof than at a lower portion thereof.

The inner section IS may be disposed between the first section SS1 and the second section SS2 in the first direction, and may refer to a portion where length L0 along the first direction is substantially the same. In the present specification, the length being substantially the same may refer to approximately the same and may also include a difference within a process error (e.g., a difference within 10%). The first section SS1 and the second section SS2 may be side surface sections disposed on one side and the other side of the inner section IS in the first direction, respectively.

One bottom gate electrode 1310 or one cell insulating layer 132 may be entirely disposed at a lower portion of the inner section IS, so that a lower portion surface of the inner section IS is configured as a flat surface.

In an embodiment, a length of each of the first section SS1 and the second section SS2 in the first direction (the Y-axis direction in the drawings) may sequentially or gradually decrease from an upper portion thereof to a lower portion thereof. For example, the plurality of gate electrodes 130 may be disposed at a lower portion of each of the first section SS1 and the second section SS2, and a lower portion surface or a side surface of each of the first section SS1 and the second section SS2 may have a stair shape including one surface (an upper portion surface of FIG. 6) and a side surface of the plurality of gate electrodes 130.

First, the first section SS1 will be described in detail, and then the second section SS2 will be described in detail. In the present specification, the length may refer to a length in the first direction (the Y-axis direction in the drawings) or an extension direction (e.g., first direction) of the gate electrode 130.

The first section SS1 may have a first length L 11 at an upper portion of the first section SS1. In this case, the upper portion of the first section SS1 may be based on one surface (an upper portion surface of FIG. 6) of a first gate electrode 1301. More specifically, the first section SS1 may have the first length L11 between boundaries between side surfaces of the first gate electrode 1301 disposed at an upper portion and the interlayer insulating layer 132m disposed at a lower portion of the first gate electrode 1301 and the inner section IS.

The first section SS1 may have a second length L12 that is less than the first length L11 between boundaries between side surfaces of a second gate electrode 1302 disposed at a lower portion of the first gate electrode 1301 and the interlayer insulating layer 132m disposed at a lower portion of the second gate electrode 1302 and the inner section IS. Additionally, the first section SS1 may have a third length L13 that is less than the second length L12 between boundaries between side surfaces of a third gate electrode 1303 disposed at a lower portion of the second gate electrode 1302 and the interlayer insulating layer 132m disposed at a lower portion of the third gate electrode 1303 and the inner section IS. Additionally, the first section SS1 may have a fourth length L14 that is less than the third length L13 between boundaries between side surfaces of a fourth gate electrode 1304 disposed at a lower portion of the third gate electrode 1303 and the interlayer insulating layer 132m disposed at a lower portion of the fourth gate electrode 1304 and the inner section IS. This shape may be repeated until reaching the bottom gate electrode 1310 or the cell insulating layer 132 disposed at a lower portion of the inner section IS. For example, a length at a lower portion of the first section SS1 may be substantially zero.

The second section SS2 may have a fifth length L21 at an upper portion of the second section SS2. In this case, the upper portion of the second section SS2 may be based on the one surface (the upper portion surface of FIG. 6) of the first gate electrode 1301. More specifically, the second section SS2 may have the fifth length L21 between boundaries between side surfaces of the first gate electrode 1301 disposed at the upper portion and the interlayer insulating layer 132m disposed at the lower portion of the first gate electrode 1301 and the inner section IS.

The second section SS2 may have a sixth length L22 that is less than the fifth length L21 between boundaries between side surfaces of the second gate electrode 1302 and the interlayer insulating layer 132m disposed at the lower portion of the second gate electrode 1302 and the inner section IS. Additionally, the second section SS2 may have a seventh length L23 that is less than the sixth length L22 between boundaries between side surfaces of the third gate electrode 1303 and the interlayer insulating layer 132m disposed at the lower portion of the third gate electrode 1303 and the inner section IS. Additionally, the second section SS2 may have an eighth length L24 that is less than the seventh length L23 between boundaries between side surfaces of the fourth gate electrode 1304 and the interlayer insulating layer 132m disposed at the lower portion of the fourth gate electrode 1304 and the inner section IS. This shape may be repeated until reaching the bottom gate electrode 1310 or the cell insulating layer 132 disposed at the lower portion of the inner section IS. For example, a length at a lower portion of the second section SS2 may be substantially zero.

In an embodiment, a difference between the length (hereinafter referred to as an upper length) at the upper portion and the length (hereinafter referred to as a lower length) at the lower portion in each of the first section SS1 and the second section SS2 or a reference length change amount (a reference length difference or a reference length deviation) in the first section SS1 and the second section SS2 may be controlled or adjusted so that a defect occurring near a corner of the buffer insulating portion 132p is prevented. This will be explained in more detail below.

A distance or an interval between top surfaces (upper surfaces of FIG. 6) of adjacent gate electrodes 130 among the plurality of gate electrodes 130 in a third direction (the Z-axis direction in the drawings) may be referred to as a reference thickness SD2. For example, a distance or an interval between one surface of the first gate electrode 1301 and one surface of the second gate electrode 1302, a distance or an interval between one surface of the second gate electrode 1302 and one surface of the third gate electrode 1303, or a distance or an interval between one surface of the third gate electrode 1303 and one surface of the fourth gate electrode 1304 may be the reference thickness SD2.

An amount in which the length of the upper section US provided in the first or second section SS1 or SS2 or the lower pad area PL differs in the reference thickness SD2 may be referred to as the reference length change amount. For example, the reference length change amount in the first section SS1 may refer to a difference between the first length L11 and the second length L12, a difference between the second length L12 and the third length L13, or a difference between the third length L13 and the fourth length L14. For example, the reference length change amount in the second section SS2 may refer to a difference between the fifth length L21 and the sixth length L22, a difference between the sixth length L22 and the seventh length L23, or a difference between the seventh length L23 and the eighth length L24. For example, a length difference on surfaces of two adjacent gate electrodes 130 in the upper section US may be referred to as a reference length change amount DV2 in the upper section US.

If the reference length change amount is large, the section may be considered to have a relatively gentle or non-steep slope, and if the reference length change amount is small, the section may be considered to have a relatively steep slope. The reference length may correspond to a reciprocal of a slope.

In an embodiment, a difference between the upper length and the lower length may be greater in the first section SS1 and the second section SS2 than at one of the sides of the upper section US provided in the lower pad area PL2. The difference between the upper length and the lower length in the first section SS1 may be the first length L11, and the difference between the upper length and the lower length in the second section SS2 may be the fifth length L21. A difference between the upper length and the lower length at one of the sides of the upper section US provided in the lower pad area PL2 may be a length DV1 that is less than the first length L11 and the fifth length L21.

For example, a difference between the upper length and the lower length at one of the sides of the first section SS1, the second section SS2, or the upper section US may be determined based on a thickness corresponding to a thickness SD1 of the buffer insulating portion 132p. Here, the thickness SD1 of the buffer insulating portion 132p may refer to a distance along the third direction (the Z-axis direction in the drawings) between an upper portion surface of the buffer insulating portion 132p disposed on the same plane as an upper portion surface of the gate electrode 130 and an upper portion surface of the bottom gate electrode 1310 or the cell insulating layer 132 disposed at the lower portion of the inner section IS.

A first distance between the inner section IS and a gate electrode 130 and a second distance between the inner section IS and the gate electrode 130 are greater than a third distance. The first distance is in the first section SS1, and the second distance is in the second section SS2. The third distance is a distance between the upper section US and the gate electrode 130 or a distance between an inner section of the upper section US and the gate electrode 130. The inner section of the upper section US may refer to a portion other than side surface sections and may refer to a portion where length in the first direction is substantially the same. For example, the first distance may refer to a maximum distance between the inner section IS and the gate electrode 130 in the first section SS1 or a distance between the inner section IS and the uppermost gate electrode at a portion where the first section SS1 is positioned, the second distance may refer to a maximum distance between the inner section IS and the gate electrode 130 in the second section SS2 or a distance between the inner section IS and the uppermost gate electrode at a portion where the second section SS2 is positioned, and the third distance may refer to a maximum distance between the upper section US (e.g., the inner section of the upper section US) and the gate electrode 130 in the upper section US or a distance between the upper section US (e.g.. the inner section of the upper section US) and the uppermost gate electrode at a portion where the upper section US is positioned.

Alternatively, the reference length change amount in the first section SS1 and the reference length change amount in the second section SS2 may be greater than the reference length change amount DV2 at one of the sides of the upper section US provided in the lower pad area PL2. For example, a ratio of the reference length change amount in the first section SS1 or the second section SS2 to the reference length change amount DV2 at one of the sides of the upper section US may be greater than or equal to 2 times. More specifically, the ratio of the reference length change amount in the first section SS1 or the second section SS2 to the reference length change amount DV2 at one of the sides of the upper section US may be about 2 to about 100 times. When the above-mentioned ratio is greater than or equal to 2 times, the side surface section may have a gentle/less steep slope. If the above-mentioned ratio is less than or equal to 100 times, an entire length L of the buffer insulating portion 132p may be prevented from increasing greater than or equal to a certain level. However, the embodiment is not limited thereto. Therefore, the ratio of the reference length change amount in the first section SS1 or the second section SS2 to the reference length change amount DV2 at one of the sides of the upper section US may be less than 2 times or may exceed 100 times.

When the first section SS1 and the second section SS2 have a gentler/more non-steep slope than one of the sides of the upper section US, a defect or the like occurring near a corner of the buffer insulating portion 132p that is a corner formed at a portion where a lower surface or a side surface of the first and/or second section SS1 and/or SS2 meets a bottom surface of the inner section IS, may be prevented.

For reference, if the first section and/or the second section have a relatively small difference between the upper length and the lower length or a relatively small reference length change amount to thereby have a steep slope unlike the embodiment, a bonding portion of a film of an insulating layer formed near the corner of the buffer insulating portion may not be strong. Accordingly, a defect in which a gap occurs in an insulating layer included in the buffer insulating portion near the corner of the buffer insulating portion may occur. When the defect occurs, the defect may cause various problems in a subsequent process. For example, a metal residue may remain stuck in the gap formed in the insulating layer to thereby deteriorate a characteristic of the semiconductor device. On the other hand, in the embodiment of the present disclosure, the characteristic of the semiconductor device may be improved by preventing a defect or the like near the corner of the buffer insulating portion 132p.

In this case, a side surface of one of the sides of the upper section US of the lower pad area PL may include a vertical surface perpendicular to the second substrate 110 or an inclined surface with a sharp slope. In an embodiment, a lower portion surface or a side surface of the first section SS1 and/or the second section SS2 may have a stair shape to stably have a gentler/less steep slope than the upper section US including the vertical surface or the inclined surface with the sharp/steep slope. As a result, the defect or the like near the corner of the buffer insulating portion 132p may be effectively prevented.

In an embodiment, the length L0 of the inner section IS in the first direction (the Y-axis direction in the drawings) may be equal to or less than a sum of an entire length of the first section SS1 and an entire length of the second section SS2. Here, the entire length of the first section SS1 may refer to the largest length among the lengths of the first section SS1 in the first direction, and, for example, may be the first length L11 that is the upper length of the first section SS1. The entire length of the second section SS2 may refer to the largest length among the lengths of the second section SS2 in the first direction, and, for example, may be the fifth length L21 that is the upper length of the second section SS2. Accordingly, entire lengths of the first section SS1 and the second section SS2 that are the side surface sections may be sufficiently secured so that the side surface section has a gentle/less steep slope.

For example, a ratio of the length L0 of the inner section IS to the entire length L of the buffer insulating portion 132p in the first direction (the Y-axis direction in the drawings) may be 10% to 50%. Here, the entire length L of the buffer insulating portion 132p may refer to the largest length among lengths of the buffer insulating portion 132p in the first direction. When the above-mentioned ratio is less than or equal to 50%, the side surface section may have the gentle slope. If the above-mentioned ratio is greater than or equal to 10%, process stability may be improved. However, the embodiment is not limited thereto, and a ratio (L0/L) of the length L0 of the inner section IS to the entire length L of the buffer insulating portion 132p in the first direction may be less than 10% or may exceed 50%.

In an embodiment, a difference between the upper length and the lower length with respect to the thickness SD1 of the buffer insulating portion 132p may be greater in the second section SS2 than in the first section SS1. In this case, the difference between the upper length and the lower length in the first section SS1 may be the first length L11, and the difference between the upper length and the lower length in the second section SS2 may be the fifth length L21. Accordingly, the fifth length L21 may be greater than the first length L11. Alternatively, the reference length change amount in the second section SS2 may be greater than the reference length change amount in the first section SS1. That is, the buffer insulating portion 132p may have an asymmetric shape in the first direction (the Y-axis direction in the drawings), and the first section SS1 and the second section SS2 may have an asymmetric shape based on the inner section IS in the first direction.

When the second section SS2 has a gentler/less steep slope than the first section SS1, it is possible to more effectively prevent a defect or the like from occurring in the buffer insulating portion 132p in the second section SS2. Additionally, the upper length (for example, the first length L 11) of the first section SS1 may be made relatively small so that the entire length L of the buffer insulating portion 132p is prevented from increasing greater than or equal to a certain level.

Here, the first section SS1 may include a plurality of dummy portions DB that are disposed at surfaces (upper portion surfaces of FIG. 6) of the plurality of gate electrodes in the first direction (the Y-axis direction in the drawings), have dummy lengths LD1, and are sequentially disposed in the first direction. For example, a side surface or a lower portion surface of the first section SS1 may have stair shapes with the same length. For example, the dummy length LD1 of the first section SS1 may be substantially the same as a dummy length D1 of the pad insulating portion 132i provided in the dummy section DS.

For example, thicknesses of the plurality of dummy portions DB may sequentially decrease or heights of lower surfaces of the plurality of dummy portions DB may increase as the distance between the plurality of dummy portions DB and the inner section IS increases in the first direction. The dummy length LD 1 may correspond to the reference length change amount in the first section SS1. The first section SS1 may include the plurality of dummy portions DB with substantially the same reference length change amount or substantially the same dummy lengths LD1 to prevent the entire length L of the buffer insulating portion 132p from becoming greater than or equal to a certain level.

The second section SS2 may include a first portion BP1 that is disposed at top surfaces (upper surfaces of FIG. 6) of the plurality of gate electrodes 130 in the first direction (the Y-axis direction in the drawings) and has a first bottom length LD2 and a second portion BP2 that is disposed at surfaces (upper surfaces of FIG. 6) of the plurality of gate electrodes 130 in the first direction (the Y-axis direction in the drawings) and has a second bottom length LD3 greater than the first bottom length LD2. Each of the first and second bottom lengths LD2 and LD3 may be greater than the dummy length LD1. For example, the first and second bottom lengths LD2 and LD3 of the second section SS2 may be substantially equal to the first and second bottom lengths D2 and D3 of the pad insulating portion 132i provided in the pad section PS.

The second portion BP2 may be disposed in the first direction with a plurality of first portions BP1 periodically. In this case, orders or arrangements of the first portion BP1 and the second portion BP2 may have a shape that is the same as or corresponds to orders or arrangements of the first pad portion PP1 and the second pad portion PP2 of at least a portion of the pad area PA or a shape symmetrical to the shape of the first portion BP1 and the second portion BP2. The symmetrical shape may refer to having a shape that is symmetrical in the first direction.

For example, thicknesses of a plurality of first and second portions BP1 and BP2 may sequentially decrease or heights of lower surfaces of the plurality of first and second portions BP1 and BP2 may increase as the distance between the plurality of first and second portions BP1 and BP2 and the inner section IS increase in the first direction. Each of the first and second bottom lengths LD2 and LD3 may correspond to the reference length change amount in the second section SS2. By including the first and second portions BP1 and BP2 that have the first and second bottom lengths LD2 and LD3, respectively, a slope of the second section SS2 may be made gentler/less steep. However, the embodiment is not limited thereto. Therefore, at least one of the first and second bottom lengths LD2 and LD3 in the second section SS2 may be equal to or less than the dummy length LD1.

In an embodiment, the buffer insulating portion 132p may have a shape corresponding to the pad insulating portion 132i provided in at least the portion of the pad area PA or a shape symmetrical to the shape of pad insulating portion 132i. The symmetrical shape may refer to a shape that is symmetrical to the left and right in the first direction. For example, the reference length change amount of a dummy insulating portion 132d of the pad insulating portion 132i provided in at least a portion of the dummy section DS and the reference length change amount of the first section SS1 of the buffer insulating portion 132p may be substantially the same, and the reference length change amount of a pad insulating portion 132e of the pad insulating portion 132i provided in at least a portion of the pad area PA and the reference length change amount of the second section SS2 and the inner section IS may be substantially the same. Alternatively, the first section SS1 may have the same shape as the dummy insulating portion 132d of the pad insulating portion 132i or a shape symmetrical to the shape. In addition, the inner section IS and the second section SS2 may have a shape corresponding to the pad insulating portion 132e or a shape symmetrical to the shape. Here, the corresponding shape may refer to having the same shape except that a portion where the gate electrode 130 becomes thicker is not provided in a portion where the inner section IS and the second section SS2 are disposed and the pad portions PP1 and PP2 are thicker than another portion in the pad insulating portion 132e. In addition, the symmetrical shape may refer to having a shape symmetrical to the corresponding shape described above. This is because a process is performed to selectively increase thicknesses of the pad portions PP1 and PP2 after the recess portion RP and the buffer recess portion BR are formed.

For example, the buffer insulating portion 132p may have a size that is substantially the same as at least a portion of the pad area PA. Here, the having substantially the same size may refer to having a size within a process error. For example, the entire length L of the buffer insulating portion 132p may be 90% to 110% of at least one entire length of the pad area PA. However, the embodiment is not limited thereto. Therefore, the buffer insulating portion 132p may have a different size from that of at least a portion of the pad area PA, or may be formed in a separate process from the pad area PA.

As an example, the buffer insulating portion 132p of the shape described above may be formed using the same process condition as that of a forming process of the pad insulating portion 132i disposed in the pad area PA. This will be explained in more detail later in the manufacturing method of the semiconductor device 10.

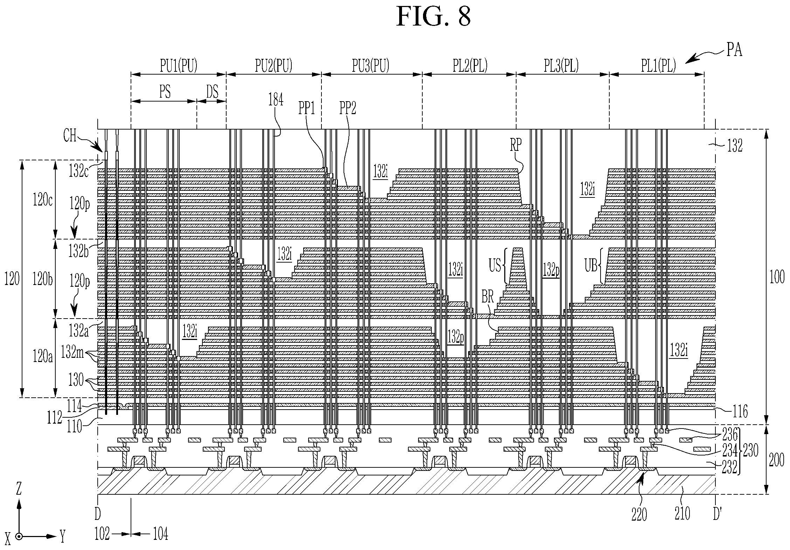

In an embodiment, the first section SS1 may be disposed adjacent to the cell array region 102 and the second section SS2 may be disposed relatively further away from the cell array region 102. A distance between the second section SS2 and the cell array region 102 is greater than a distance between the first section SS1 and the cell array region 102. In addition, the buffer insulating portion 132p may be disposed at an upper portion of a lower stacking structure, and may include an upper portion pattern including the inner section IS, the first section SS1, and the second section SS2. As an example, the buffer insulating portion 132p may have a symmetrical shape in the first direction (the Y-axis direction in the drawings) with the pad insulating portion 132i disposed in at least a portion (for example, the upper pad area PU) of the pad area PA. Another embodiment will be described in more detail later with reference to FIGS. 8 to 11.

If the buffer insulating portion 132p has the symmetrical shape with the pad insulating portion 132i provided in at least the portion of the pad area PA, the first section SS1 and the inner section IS may be disposed at a lower portion of the pad section PS, where the gate electrode 130 and the gate contact portion 184 are connected in the pad area PA. That is, in the lower structure, the gate contact portion 184 may be disposed in the first section SS1 and the inner section IS where a relatively large amount of insulating material is disposed. As a result, a problem caused by falling out, misalignment, or the like of the gate contact portion 184 may be effectively prevented.

In an embodiment, one buffer insulating portion 132p may be formed in the second stacking structure 120b including the boundary portion 120p of the second stacking structure 120b in the third pad area PA3 (e.g., the third lower pad area PL3). In addition, another buffer insulating portion 132p may be formed in the first stacking structure 120a including the boundary portion 120p of the first stacking structure 120a in the second pad area PA2 (e.g., the second lower pad area PL2). This is because the lower pad area PL is formed to have a large thickness with the pad insulating portion 132i having the upper section US so that the gate contact portion 184 has a large area or size at the boundary portion 120p of the lower structure disposed at the lower pad area PL.

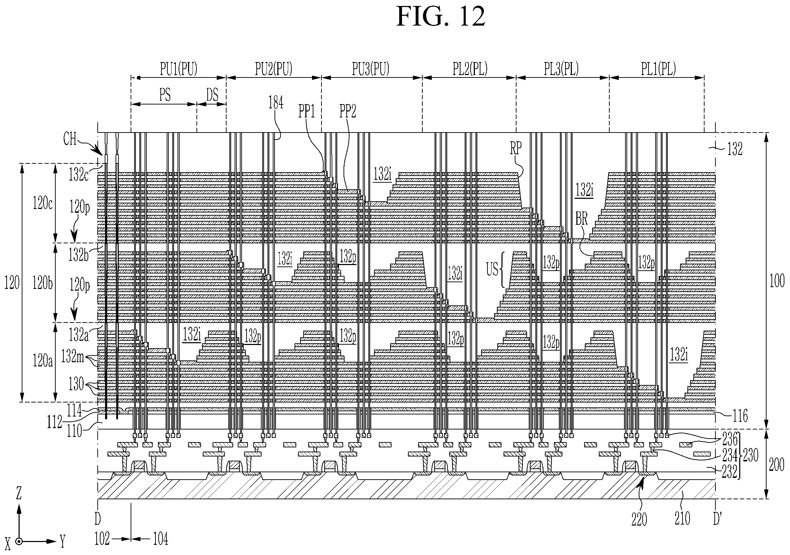

However, the embodiment is not limited thereto. When the upper pad area PU is provided in the upper structure, the buffer insulating portion 132p may be disposed in a lower structure disposed at a lower portion of the upper pad area PU. In addition, even when the upper structure is an insulating structure and the lower structure is an insulating structure, the buffer insulating portion 132p may be provided in the lower structure. This will be explained in detail later with reference to FIG. 12. As another example, one buffer insulating portion 132p may be provided, and numerous other variations are possible.

According to an embodiment, the buffer insulating portion 132p is formed in a lower structure disposed at a lower portion of the boundary portion 120p where a bonding portion of the gate contact portion 184 is disposed in the connection region 104. As a result, even when the gate contact portion 184 falls out at the boundary portion 120p, a portion of the gate contact portion 184 disposed in the upper structure is disposed at a portion of the gate contact portion 184 and the buffer insulating portion 132p disposed in the lower structure. That is, the gate contact portion 184 may have a sufficient separation distance from the gate electrode 130 by the buffer insulating portion 132p. Accordingly, a problem of damage to the gate electrode 130 due to falling out or misalignment of the gate contact portion 184 may be fundamentally prevented by the buffer insulating portion 132p.

In this case, a side surface section of the buffer insulating portion 132p may have a gentle/less steep slope, so that it is possible to prevent a defect, such as a gap in the buffer insulating portion 132p near a corner of the buffer insulating portion 132p. This may improve reliability and performance of the semiconductor device 10. The buffer insulating portion 132p may have a shape corresponding to the pad insulating portion 132i provided in at least a portion of the pad area PA or a shape symmetrical to the shape so that the buffer insulating portion 132p is formed by an easy process.

In the embodiment described above, the difference between the upper length and the lower length is greater in the second section SS2 than in the first section SS1, and the reference length change amount in the second section SS2 is greater than the reference length change amount in the first section SS1. However, the embodiment is not limited thereto. Therefore, the difference between the upper length and the lower length may be the same in the first section SS1 and the second section SS2, or the reference length change amount in the first section SS1 and the reference length change amount in the second section SS2 may be the same. Even in this case, the difference between the upper length and the lower length may be greater in the first and/or second sections SS1 and SS2 than in one side of the upper section US. Alternatively, the reference length change amount in the first and/or second sections SS1 and SS2 may be greater than the reference length change amount DV2 in one side of the upper section US. Then, the defect that may occur near the corner of the buffer insulating portion 132p may be prevented. Numerous other variations are possible.

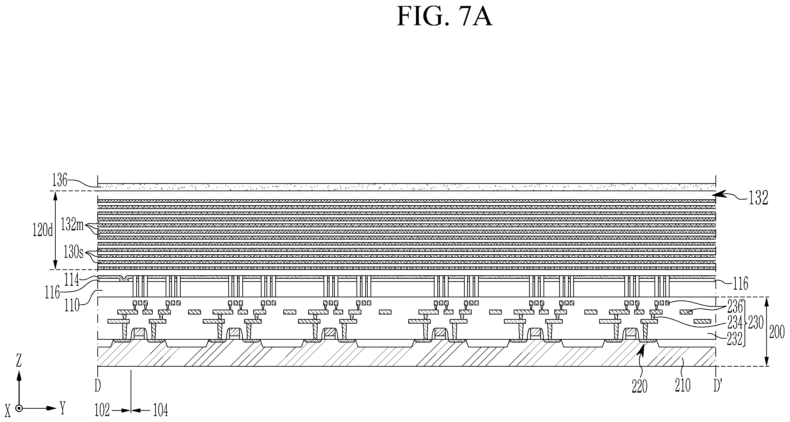

An example of the manufacturing method for manufacturing the semiconductor device 10 having the above structure will be described in detail with reference to FIGS. 7A to 7I together with FIGS. 1 to 6. A detailed description of a portion that has already been described will be omitted, and a portion that has not been described will be described in detail.

FIGS. 7A to 7I are partial cross-sectional views illustrating the method for manufacturing the semiconductor device according to an embodiment. FIGS. 7A to 7I show the partial cross-sectional views of the semiconductor device 10 cut along a line D-D' of FIG. 1. Hereinafter, the manufacturing method of the semiconductor device 10 will mainly describe the gate stacking structure 120, the channel structure CH, the gate contact portion 184, the cell insulating layer 132 including the buffer insulating portion 132p, and the separation structure 146.

As shown in FIGS. 7A to 7F, a plurality of sacrificial insulating layers 130s and the plurality of cell insulating layers 132 may be alternately stacked above the circuit region 200 including the peripheral circuit structure to form a stacking structure 120s. Here, the cell insulating layer 132 may include the pad insulating portion 132i and the buffer insulating portion 132p. The second substrate 110, the horizontal insulating layer 116, the second horizontal conductive layer 114, or the like may be further formed between the circuit region 200 and the stacking structure 120s. In addition, a channel sacrificial layer 124s and a wire sacrificial layer 184s extending into or penetrating the stacking structure 120s may be formed.

For simple explanation and clear understanding, the drawings illustrate that the stacking structure 120s includes a plurality of stacking structures 120d, 120e, and 120f including a first stacking structure 120d, a second stacking structure 120e, and a third stacking structure 120f. However, the embodiment is not limited thereto, and the stacking structure 120s may include two or four or more stacking structures.

First, as shown in FIG. 7A, the horizontal insulating layer 116, the second horizontal conductive layer 114, and the first stacking structure 120d may be formed above or on the second substrate 110. That is, the cell insulating layer 132 and the sacrificial insulating layer 130s may be alternately stacked. The first upper insulating layer 132a may be disposed at an upper portion of the first stacking structure 120d.

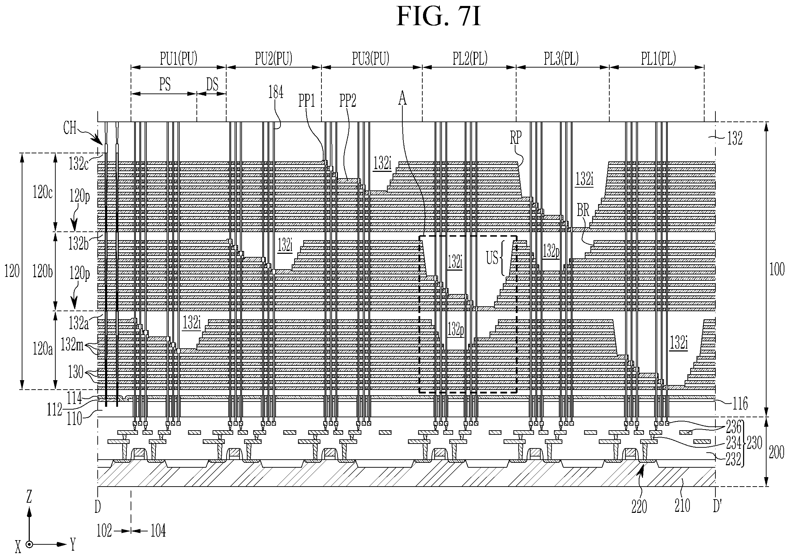

Here, the sacrificial insulating layer 130s may be a layer that is replaced with the gate electrode 130 of FIG. 7I through a subsequent process, and at least a portion of the horizontal insulating layer 116 may be a layer that is replaced with the first horizontal conductive layer 112 of FIG. 7I through a subsequent process. That is, the sacrificial insulating layer 130s may be formed to correspond to a portion where the gate electrode 130 is to be formed, and the horizontal insulating layer 116 may be formed to include a portion where the first horizontal conductive layer 112 is to be formed.

The horizontal insulating layer 116 and/or the sacrificial insulating layer 130s may be formed of a different material from that of the interlayer insulating layer 132m and/or the first upper insulating layer 132a. For example, the interlayer insulating layer 132m or the first upper insulating layer 132a may include silicon oxide, silicon nitride, silicon oxynitride, a low dielectric constant material, or the like. For example, the sacrificial insulating layer 130s may be silicon, silicon oxide, silicon carbide, silicon nitride, or the like, and may be formed of a different material from that of the interlayer insulating layer 132m.

In an embodiment, an etching stop layer 136 may be formed on the first upper insulating layer 132a. The etching stop layer 136 may be a layer for protecting the first stacking structure 120d during an etching process, and for example, the etching stop layer 136 may be a hard mask layer.

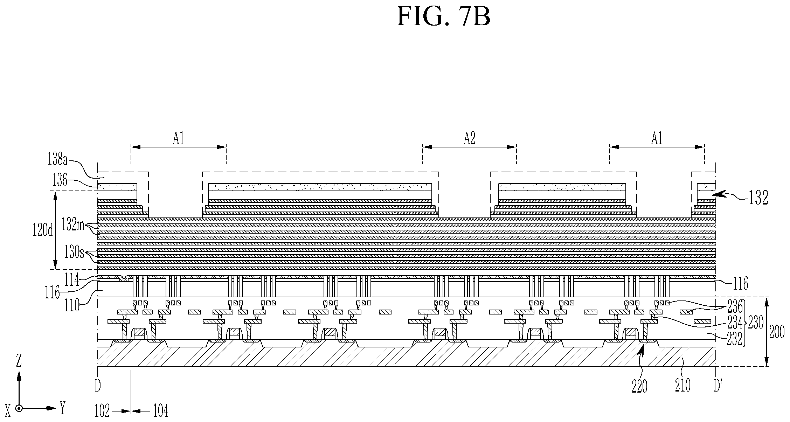

Subsequently, as shown in FIGS. 7B to 7D, the recess portion RP and the buffer recess portion BR may be formed in the first stacking structure 120d. Here, the recess portion RP may be formed to correspond to the first upper pad area PU1 and the first lower pad area PL1, or may be formed to correspond to the pad insulating portion 132i provided in the first upper pad area PU1 and the first lower pad area PL1. The buffer recess portion BR may be formed to correspond to the buffer insulating portion 132p. As an example, the buffer recess portion BR is disposed to correspond to the second lower pad area PL2, but the embodiment is not limited thereto. The recess portion RP and the buffer recess portion BR may be formed by a sequential etching process using mask layers 138a, 138b, and 138c.

More specifically, as shown in FIG. 7B, a first etching process in which the first mask layer 138a is formed and a portion of the recess portion RP and a portion of the buffer recess portion BR are formed at the first stacking structure 120d exposed by the first mask layer 138a may be performed. For example, the first mask layer 138a may be a photoresist layer, and may be formed by a photolithography process. By repeating a trim process using the first mask layer 138a, the portion of the recess portion RP and the portion of the buffer recess portion BR may be formed. For example, the portion of the recess portion RP and the portion of the buffer recess portion BR may be formed by performing a stepwise etching process on the sacrificial insulating layer 130s and the cell insulating layer 132 while sequentially increasing an exposed region using the first mask layer 138a.

In this case, a first area A1 of the first mask layer 138a for forming the recess portion RP in the first mask layer 138a and a second area A2 of the first mask layer 138a for forming the buffer recess portion BR may have a symmetrical shape. In this case, in the first etching process, a process condition forming the portion of the recess portion RP forming a portion of the pad section PS and a process condition forming the portion of the buffer recess portion BR forming a portion of the second section SS2 may be the same. In this case, the recess portion RP and the buffer recess portion BR have a symmetrical shape. Accordingly, a process condition at one side of the recess portion RP and a process condition at the other side of the buffer recess portion BR may be the same, and a process condition at the other side of the recess portion RP and a process condition at one side of the buffer recess portion BR may be the same.

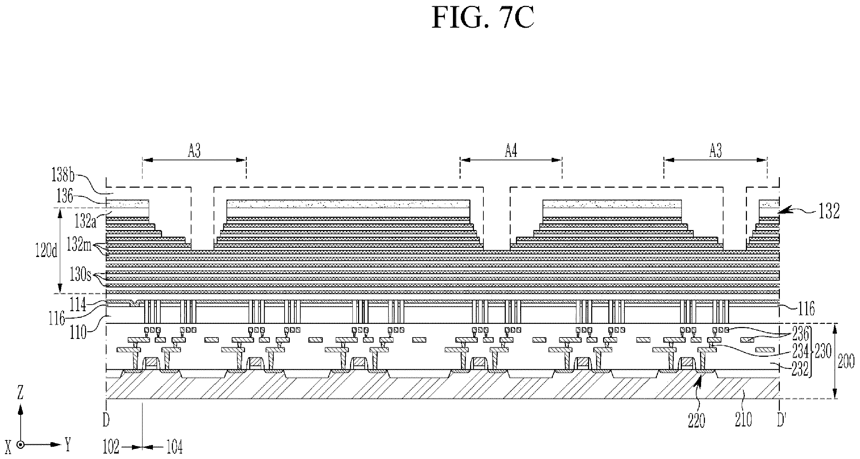

Subsequently, as shown in FIG. 7C, a second etching process in which the second mask layer 138b is formed and another portion of the recess portion RP and another portion of the buffer recess portion BR are formed at the first stacking structure 120d exposed by the second mask layer 138b, may be performed. For example, the second mask layer 138b may be a photoresist layer, and may be formed through a photolithography process. By repeating a trim process using the second mask layer 138b, the other portion of the recess portion RP and the other portion of the buffer recess portion BR may be formed. For example, the other portion of the recess portion RP and the other portion of the buffer recess portion BR may be formed by performing a stepwise etching process on the sacrificial insulating layer 130s and the cell insulating layer 132 while sequentially increasing an exposed region using the second mask layer 138b.

In this case, a third area A3 of the second mask layer 138b for forming the recess portion RP in the second mask layer 138b and a fourth area A4 of the second mask layer 138b for forming the buffer recess portion BR may have a symmetrical shape. In this case, in the second etching process, a process condition forming the other portion of the recess portion RP forming a portion of the pad section PS and a process condition forming the other portion of the buffer recess portion BR forming a portion of the second section SS2 may be the same. In this case, the recess portion RP and the buffer recess portion BR have a symmetrical shape. Accordingly, a process condition at one side of the recess portion RP and a process condition at the other side of the buffer recess portion BR may be the same, and a process condition at the other side of the recess portion RP and a process condition at one side of the buffer recess portion BR may be the same.

As a result, the recess portion RP may be formed at an upper portion of the first stacking structure 120d in the first upper pad area PU1 and the first lower pad area PL1. In addition, in the second lower pad area PL2, the buffer recess portion BR including the inner section IS, the first section SS1, and the second section SS2 may be formed at the upper portion of the first stacking structure 120d. Although the first and second etching processes are used in the above description, the embodiment is not limited thereto. A single etching process may be used, or three or more etching processes may be used.

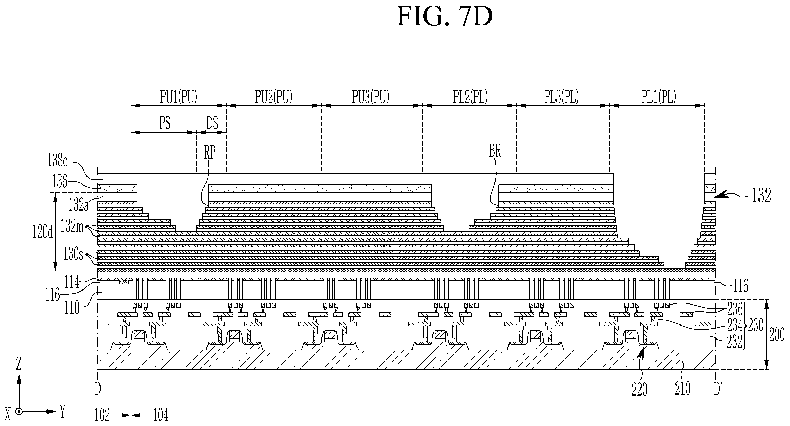

Subsequently, as shown in FIG. 7D, the recess portion RP corresponding to the first lower pad area PL1 including the upper section US may be formed using the third mask layer 138c. The first lower pad area PL1 may be exposed to be etched downward to an extent corresponding to the upper section US using the third mask layer 138c.

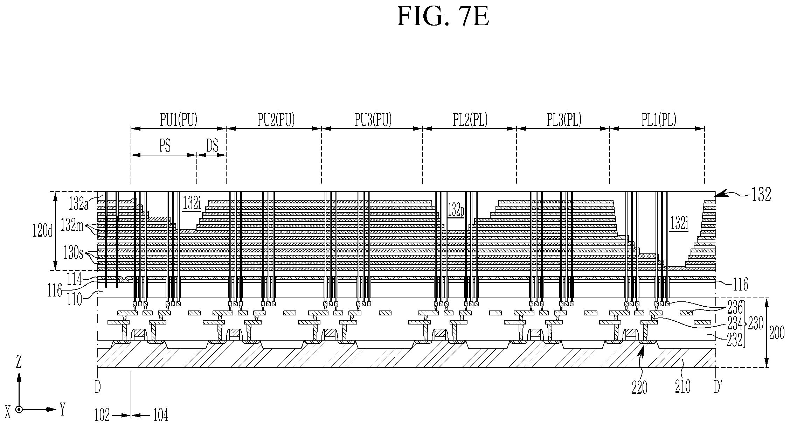

Subsequently, as shown in FIG. 7E, the pad insulating portion 132i and the buffer insulating portion 132p may be formed, and the channel sacrificial layer 124s and the wire sacrificial layer 184s may be formed.

Before the pad insulating portion 132i and the buffer insulating portion 132p are formed, a thickness of the sacrificial insulating layer 130s may be partially increased and the etching stop layer 136 may be removed. That is, the thickness of the sacrificial insulating layer 130s may be increased in a portion corresponding to the pad portion PP1 or PP2 of the gate electrode 130 of FIG. 7I compared with another portion. For example, after an additional sacrificial insulating layer is formed, the thickness of the sacrificial insulating layer 130s of the pad portion PP1 or PP2 may be partially increased by patterning so that the additional sacrificial insulating layer remains on the pad portion PP1 or PP2. In this case, a thickness of the sacrificial insulating layer 130s disposed in the recess portion RP may be increased, and a thickness of the sacrificial insulating layer 130s disposed in the buffer recess portion BR may be maintained without increasing an additional sacrificial insulating layer. The etching stop layer 136 may be formed before or after the thickness increasing process.

Subsequently, the pad insulating portion 132i and the buffer insulating portion 132p that are in or at least partially fill the recess portion RP and the buffer recess portion BR, respectively, may be formed. For example, the pad insulating portion 132i and the buffer insulating portion 132p may be formed together using the same process. According to an embodiment, in the first stacking structure 120d, the pad insulating portion 132i and the buffer insulating portion 132p may be formed separately from the first upper insulating layer 132a before or after a process of forming the first upper insulating layer 132a, and may be formed as a portion of the first upper insulating layer 132a.

Subsequently, the channel sacrificial layer 124s extending into the first stacking structure 120d may be formed in the cell array region 102, and the wire sacrificial layer 184s extending into or penetrating the first stacking structure 120d may be formed in the connection region 104. For example, after a penetrating portion that extends into or penetrates the first stacking structure 120d is formed, a sacrificial material may be deposited to form the channel sacrificial layer 124s and the wire sacrificial layer 184s. For example, the penetrating portion may be formed by an etching process (e.g., a plasma etching process), and the sacrificial material may include polycrystalline silicon, tungsten, or the like.

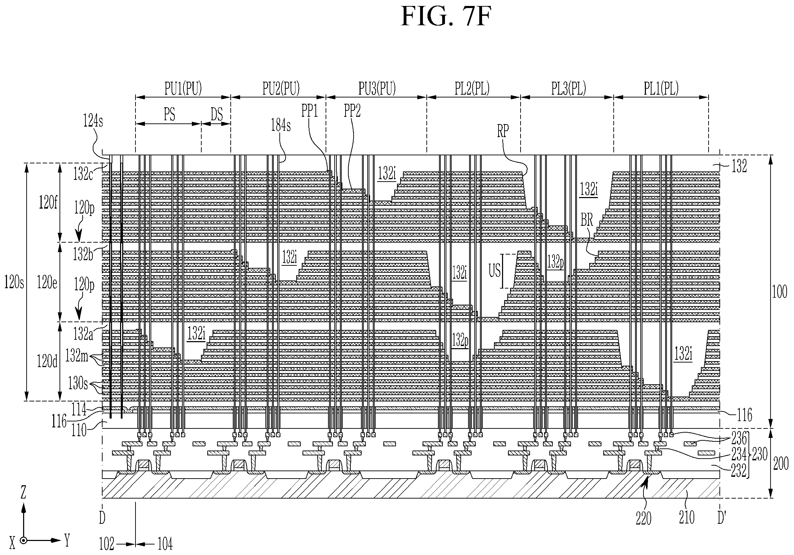

Subsequently, as shown in FIG. 7F, the second stacking structure 120e and the third stacking structure 120f may be formed.

More specifically, the second stacking structure 120e may be formed by alternately stacking the cell insulating layer 132 and the sacrificial insulating layer 130s above or on the first stacking structure 120d. In this case, the cell insulating layer 132 may include the pad insulating portion 132i and the buffer insulating portion 132p, and may include the second upper insulating layer 132b disposed at an upper portion of the second stacking structure 120e. In addition, the channel sacrificial layer 124s and the wire sacrificial layer 184s extending into or penetrating the second stacking structure 120e may be formed. Since a description related to the first stacking structure 120d may be applied to a manufacturing process of the sacrificial insulating layer 130s, the cell insulating layer 132, the channel sacrificial layer 124s, and the wire sacrificial layer 184s of the second stacking structure 120e, a detailed description of the manufacturing process is omitted.

Subsequently, the third stacking structure 120f may be formed by alternately stacking the cell insulating layer 132 and the sacrificial insulating layer 130s above or on the second stacking structure 120e. In this case, the cell insulating layer 132 may include the pad insulating portion 132i and the third upper insulating layer 132c disposed at an upper portion of the third stacking structure 120f. In addition, the channel sacrificial layer 124s and the wire sacrificial layer 184s extending into or penetrating the third stacking structure 120f may be formed. Since a description related to the first stacking structure 120d may be applied to a manufacturing process of the sacrificial insulating layer 130s, the cell insulating layer 132, the channel sacrificial layer 124s, and the wire sacrificial layer 184s of the third stacking structure 120f, a detailed description of the manufacturing process is omitted.

In an embodiment, the channel sacrificial layer 124s may be formed to correspond to the channel structure CH of FIG. 7G. The wire sacrificial layer 184s may be formed to correspond to the gate contact portion 184 of FIG. 7I.

Subsequently, as shown in FIGS. 7G to 7I, the channel sacrificial layer 124s and the wire sacrificial layer 184s may be removed, and the channel structure CH, the gate contact portion 184, and the gate electrode 130 may be formed.

More specifically, in FIG. 7G, the channel structure CH may be formed, and the wire penetrating portion OH may be formed. The upper separation region 148 may be further formed at a portion of the second stacking structure 120e. The upper separation region 148 of FIG. 2 may be formed by forming an upper separation opening by an etching process using a mask layer and depositing an insulating material within the upper separation opening.

In other words, the channel structure CH may be formed within a penetrating portion formed by removing the channel sacrificial layer 124s of FIG. 7F. For example, the gate dielectric layer 150 of FIG. 3, the channel layer 140 of FIG. 3, and the core insulating layer 142 of FIG. 3 may be sequentially formed in or to at least partially fill the penetrating portion, and the channel pad 144 of FIG. 3 may be formed on the channel layer 140 to form the channel structure CH. In this case, the first blocking layer 156a of FIG. 3 of the gate dielectric layer 150 may not be formed, but may be formed in another later process.

In addition, the wire sacrificial layer 184s of FIG. 7F may be removed to form the wire penetrating portion OH. A portion of the cell insulating layer 132 covering or overlapping the channel structure CH may be further formed before the wire penetrating portion OH is formed. The wire penetrating portion OH may be extended to the circuit region 200 by extending into or penetrating the stacking structure 120s and the substrate insulating portion 110i of the second substrate 110. The wire penetrating portion OH may be formed to expose a pad portion of the circuit region 200.

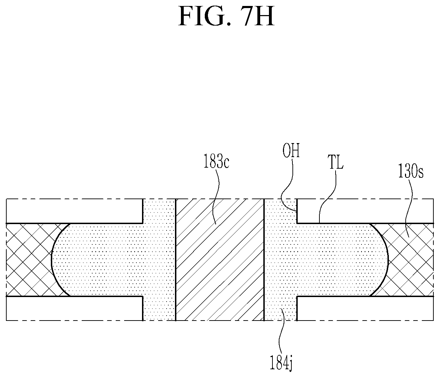

Subsequently, as shown in FIG. 7H, a tunnel portion may be formed through the wire penetrating portion OH, and a preliminary insulating layer 184j and a vertical sacrificial layer 183c may be formed.

More specifically, a portion of the sacrificial insulating layer 130s exposed through the wire penetrating portion OH may be removed in a horizontal direction to form the tunnel portion TL. When an etching material is introduced through the wire penetrating portion OH, the sacrificial insulating layer 130s adjacent to the wire penetrating portion OH may be etched in the horizontal direction to form the tunnel portion TL. In this case, etching may also be performed in upper and lower directions of the sacrificial insulating layer 130s, so that the tunnel portion TL is formed to have a thickness slightly thicker than that of the sacrificial insulating layer 130s. Since the tunnel portion TL is formed by etching in the horizontal direction through the wire penetrating portion OH, a side surface of the tunnel portion TL may have a relatively small slope, a convex shape, or a rounded portion.

Subsequently, the preliminary insulating layer 184j and the vertical sacrificial layer 183c may be in the tunnel portion TL and the wire penetrating portion OH.

The preliminary insulating layer 184j may be a layer constituting the insulating pattern 184i of FIG. 2 by remaining a portion of the preliminary insulating layer 184j. The preliminary insulating layer 184j may not completely be in or fill the tunnel portion TL formed corresponding to the pad portion PP1 or PP2 of the connection gate electrode 130c of FIG. 2 having a relatively large thickness, and may be formed to be in or to at least partially fill the tunnel portion TL formed corresponding to the remaining gate electrode 130r of FIG. 2. This may be due to a relative thickness difference. The vertical sacrificial layer 183c may be formed to be in or at least partially fill a remaining space within the wire penetrating portion OH.

The preliminary insulating layer 184j may include a material constituting the insulating pattern 184i. The vertical sacrificial layer 183c may include a different material from that of the preliminary insulating layer 184j, and for example, may include polycrystalline silicon, tungsten, or the like. However, the embodiment is not limited thereto, and materials of the preliminary insulating layer 184j and/or the vertical sacrificial layer 183c may be variously modified.

Subsequently, as shown in FIG. 7I, the gate contact portion 184 may be formed by replacing the sacrificial insulating layer 130s of FIGS. 7F and 7G with the gate electrode 130.

First, an opening may be formed at a region corresponding to the separation structure 146 of FIG. 2 to extend into the stacking structure 120s of FIG. 7F. The sacrificial insulating layer 130s may be selectively removed by an etching process (e.g., a wet etching process) through the opening. In addition, the gate electrode 130 may be formed by filling a conductive material constituting the gate electrode 130 in a portion where the sacrificial insulating layer 130s is removed. Accordingly, the gate stacking structure 120 may be formed by replacing a region where the sacrificial insulating layer 130s is disposed with the gate electrode 130. In this case, a process of forming the first blocking layer 156a may be further performed before a process of filling the conductive material constituting the gate electrode 130.

According to an embodiment, an opening may be formed to expose the horizontal insulating layer 116. In an etching process through the opening, at least a portion of the horizontal insulating layer 116 and a portion of the gate dielectric layer 150 may be removed, and a material constituting the first horizontal conductive layer 112 may be filled to form the first horizontal conductive layer 112. In addition, the separation structure 146 may be formed by depositing an insulating material in the opening.

Subsequently, the vertical sacrificial layer 183c of FIG. 7H and a portion of the preliminary insulating layer 184j of FIG. 7H may be removed, and a conductive material may be filled to form the gate contact portion 184.

More specifically, after the vertical sacrificial layer 183c is selectively removed, the portion of the preliminary insulating layer 184j may be removed. In this case, all of the preliminary insulating layer 184j formed at the pad portion PP1 or PP2 of the connection gate electrode 130c may be removed, and the preliminary insulating layer 184j formed at the tunnel portion TL of the remaining gate electrode 130r may remain to form the insulating pattern 184i.

Subsequently, a conductive material may be deposited within the wire penetrating portion OH to form the gate contact portion 184. The gate contact portion 184 includes the connection portion 184c extending toward an inner side surface of the pad portion PP1 or PP2. Thereafter, the second wire portion 180 connected to the channel structure CH may be further formed.

According to an embodiment, the buffer insulating portion 132p may have the shape corresponding to the pad insulating portion 132i provided in at least the portion of the pad area PA or the shape symmetrical to the shape of the pad insulating portion 132i so that the buffer insulating portion 132p is formed using a process condition for forming the pad insulating portion 132i. Accordingly, the semiconductor device 10 including the buffer insulating portion 132p to have excellent reliability and performance may be manufactured through an easy process.

Hereinafter, a semiconductor device and a manufacturing method thereof according to an embodiment different from the above-described embodiment will be described in more detail with reference to FIGS. 8 to 13. A detailed description of a portion identical to or extremely similar to the portion already described will be omitted, and another portion will be described in detail.

FIG. 8 is a partial cross-sectional view schematically showing the semiconductor device according to the other embodiment. FIG. 8 shows a portion corresponding to that of FIG. 4.

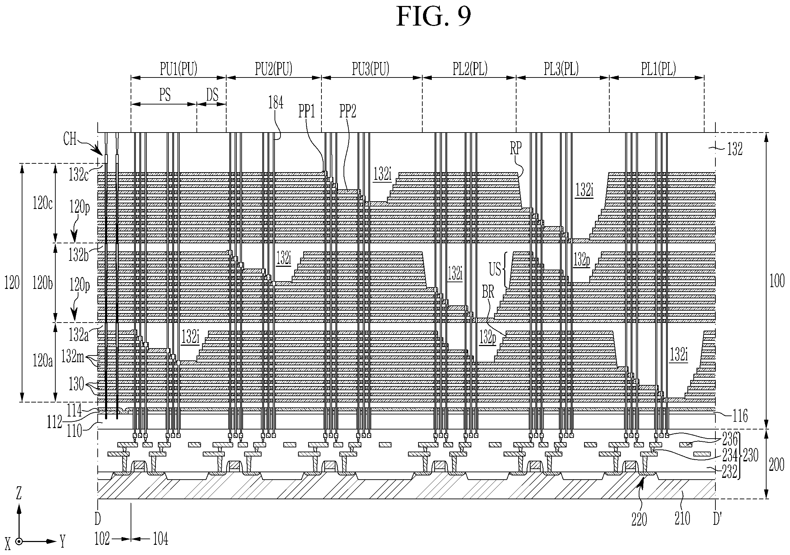

Referring to FIG. 8, in the embodiment, at least one of the buffer insulating portions 132p may include the inner section IS, the first section SS1, the second section SS2, and an extension pattern further including an upper buffer section UB disposed at upper portions of the inner section IS, the first section SS1, and the second section SS2. For example, FIG. 8 illustrates that the first section SS1 is disposed adjacent to the cell array region 102 and the second section SS2 is disposed far from the cell array region 102 so that the buffer insulating portion 132p has a symmetrical shape with the pad insulating portion 132i provided in the second lower pad area PL2. Another example will be described in more detail later with reference to FIGS. 9 to 11.

FIG. 8 illustrates that the buffer insulating portion 132p including the extension pattern is provided in the second stacking structure 120b constituting the lower structure in the third lower pad area PL3 and the buffer insulating portion 132p including the upper pattern is provided in the first stacking structure 120a constituting the lower structure in the second lower pad area PL2. However, the embodiment is not limited thereto. For example, one or more buffer insulating portions 132p including the extension pattern may be provided in the first stacking structure 120a and/or the second stacking structure 120b. The number, arrangements, or the like of the buffer insulating portion 132p including the extension pattern and the buffer insulating portion 132p including the upper pattern may be variously modified.

In an embodiment, a difference between the upper length and the lower length may be greater in the first section SS1 and the second section SS2 than at one side or the other side of the upper buffer section UB. Alternatively, the reference length change amount in the first section SS1 and the second section SS2 may be greater than the reference length change amount at one side or the other side of the upper buffer section UB. For example, a side surface of one side or the other side of the upper buffer section UB may include a vertical surface perpendicular to the second substrate 110 or an inclined surface with a sharp slope.

In an embodiment, the buffer insulating portion 132p having the extension pattern may be formed using the same process condition as that of a forming process of the pad insulating portion 132i disposed in the upper pad area PU having the upper section US. For example, in a process of forming the recess portion RP corresponding to the upper section US of the upper pad area PU, the buffer recess portion BR corresponding to the upper buffer section UB may be formed together.

For example, the upper length, the lower length, a side surface slope, and the like of the upper buffer section UB may have substantially the same values as the upper length, the lower length, a side surface slope, and the like of the upper section US of the upper pad area PU. As a result, an entire length of the buffer insulating portion 132p including the upper buffer section UB to have the extension pattern may be prevented from increasing greater than or equal to a certain level.

If the upper buffer section UB is further included, the buffer insulating portion 132p may have a relatively large thickness at the boundary portion 120p of the lower structure. Accordingly, falling out or misalignment of the gate contact portion 184 that may occur at the boundary portion 120p may be effectively prevented.

In an embodiment, the buffer insulating portion 132p provided in the upper buffer section UB may have the shape corresponding to the pad insulating portion 132i provided in at least the portion of the pad area PA or the shape symmetrical to the shape.

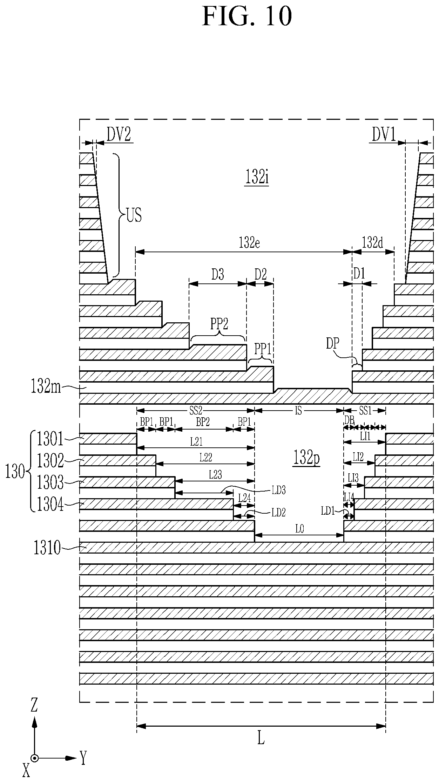

FIG. 9 is a partial cross-sectional view schematically showing a semiconductor device according to another embodiment, and FIG. 10 is an enlarged view of a portion of the semiconductor device shown in FIG. 9. FIG. 9 shows a portion corresponding to that of FIG. 4, and FIG. 10 shows a portion corresponding to that of FIG. 6.

Referring to FIG. 9 and FIG. 10, in an embodiment, the first section SS1 may be disposed far from the cell array region 102, and the second section SS2 may be disposed adjacent to the cell array region 102. A distance between the first section SS1 and the cell array region 102 is greater than a distance between the second section SS2 and the cell array region 102. As an example, the buffer insulating portion 132p may have a shape corresponding to the pad insulating portion 132i provided in at least a portion of the pad area PA in the first direction (the Y-axis direction in the drawings).

Accordingly, the second section SS2 may be disposed at a lower portion where the gate electrode 130 and the gate contact portion 184 are connected in the pad area PA. Then, a thickness of the buffer insulating portion 132p in the lower structure may correspond in proportion to a thickness of the pad insulating portion 132i in the upper structure. As a result, a problem caused by falling out, misalignment, or the like of the gate contact portion 184 may be effectively prevented.

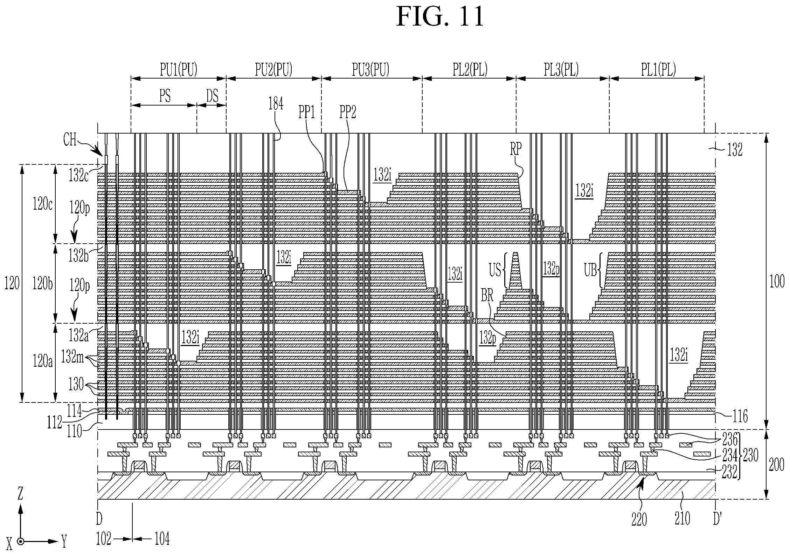

FIG. 11 is a partial cross-sectional view schematically showing a semiconductor device according to another embodiment. FIG. 11 shows a portion corresponding to that of FIG. 4.

Referring to FIG. 11, in the embodiment, at least one of the buffer insulating portions 132p may include the inner section IS, the first section SS1, the second section SS2, and the extension pattern further including the upper buffer section UB disposed at the upper portions of the inner section IS, the first section SS1, and the second section SS2. In an embodiment, the buffer insulating portion 132p provided in the upper buffer section UB may have the shape corresponding to the pad insulating portion 132i provided in at least the portion of the pad area PA or the shape symmetrical to the shape. For example, FIG. 11 illustrates that the first section SS1 is disposed far from the cell array region 102 and the second section SS2 is disposed adjacent to the cell array region 102 so that the buffer insulating portion 132p has a shape corresponding to the pad insulating portion 132i provided in the second lower pad area PL2.

FIG. 11 illustrates that the buffer insulating portion 132p including the extension pattern is provided in the second stacking structure 120b constituting the lower structure in the third lower pad area PL3 and the buffer insulating portion 132p including the upper pattern is provided in the first stacking structure 120a constituting the lower structure in the second lower pad area PL2. However, the embodiment is not limited thereto. For example, one or more buffer insulating portions 132p including the extension pattern may be provided in the first stacking structure 120a and/or the second stacking structure 120b. The number, arrangements, or the like of the buffer insulating portion 132p including the extension pattern and the buffer insulating portion 132p including the upper pattern may be variously modified.

If the upper buffer section UB is further included, the buffer insulating portion 132p may have a relatively large thickness at the boundary portion 120p of the lower structure. Accordingly, falling out or misalignment of the gate contact portion 184 that may occur at the boundary portion 120p may be effectively prevented.

FIG. 12 is a partial cross-sectional view schematically showing a semiconductor device according to another embodiment. FIG. 12 shows a portion corresponding to that of FIG. 4.

FIG. 12 illustrates that the buffer insulating portion 132p is formed at the second upper pad area PU2, the third upper pad area PU3, the second lower pad area PL2, and the third lower pad area PL3 in the first stacking structure 120a and the buffer insulating portion 132p is formed at the third upper pad area PU3, the third lower pad area PL3, and the first lower pad area PL1 in the second stacking structure 120b. In addition, FIG. 12 illustrates that the buffer insulating portion 132p includes the upper pattern and has a symmetrical shape with the pad insulating portion 132i provided in the upper pad area PU.

However, the embodiment is not limited thereto. At least one buffer insulating portion 132p may be provided in one or more pad areas PA to include the boundary portion 120p in the first and/or second stacking structures 120a and 120b.

FIG. 12 illustrates that the buffer insulating portion 132p including the extension pattern is not provided and the buffer insulating portion 132p including the upper pattern is provided, but the embodiment is not limited thereto. According to an embodiment, at least one of the buffer insulating portions 132p may be the upper pattern including the inner section IS, the first section SS1, and the second section SS2, and/or the at least one of the buffer insulating portions 132p may be the extension pattern including the inner section IS, the first section SS1, the second section SS2, and the upper buffer section UB. Alternatively, the buffer insulating portion 132p including the upper pattern may not be provided, and the buffer insulating portion 132p including the extension pattern may be provided.

According to an embodiment, the buffer insulating portion 132p may have the shape corresponding to the pad insulating portion 132i provided in at least the portion (for example, the upper pad area PU or the lower pad area PL) of the pad area PA or the shape symmetrical to the shape of the pad insulating portion 132i. As described above, the buffer insulating portion 132p may have various structures, arrangements, shapes, and the like.

In the above-described embodiment, a case in which the gate stacking structure 120 includes three gate stacking structures 120a, 120b, and 120c has been mainly described, but the embodiment is not limited thereto. Even when the gate stacking structure 120 includes two gate stacking structures or four or more gate stacking structures, the buffer insulating portion 132p may be provided at the lower structure.

An additional embodiment will be described in detail with reference to FIG. 13. The description of the above-described embodiment may be applied to FIG. 13 except for a case where reference numerals identical or similar to the above-described embodiment are differently mentioned. Hereinafter, a different portion from the portion described in the above-described embodiment will be mainly described.

FIG. 13 is a cross-sectional view schematically showing a semiconductor device according to the additional embodiment.

Referring to FIG. 13, the semiconductor device according to the embodiment may have a chip-to-chip (C2C) structure bonded by a wafer bonding method. That is, a lower chip including the circuit region 200a formed above or on a first substrate 210a may be manufactured, an upper chip including a cell region 100a formed above or on a second substrate 110a may be manufactured, and then the semiconductor device may be manufactured by bonding the lower chip and the upper chip.

The circuit region 200a may include the first substrate 210a, the circuit element 220, the first wire portion 230, and a first bonding structure (or a first junction structure) 238 electrically connected to the first wire portion 230 and disposed at a surface facing the cell region 100a. A region other than the first bonding structure 238 may be covered or overlapped by the first insulating layer 232 at the side facing the cell region 100a.

The cell region 100a may include the second substrate 110a, the gate stacking structure 120, the channel structure CH, the second wire portion 180, and the second bonding structure 194 electrically connected to the second wire portion 180 and disposed at a surface facing the circuit region 200a. A region other than the second bonding structure 194 may be covered or overlapped by an insulating layer 196.

In an embodiment, the second substrate 110a may be a semiconductor substrate including a semiconductor material. For example, the second substrate 110a may be a semiconductor substrate made of a semiconductor material or may be a semiconductor substrate in which a semiconductor layer is formed on a base substrate. For example, the second substrate 110a may include monocrystalline or polycrystalline silicon, germanium, silicon-germanium, a silicon-on-insulator, a germanium-on-insulator, or the like. Alternatively, the second substrate 110a may include a support member including an insulating layer or an insulating material. This is because the semiconductor substrate provided in the cell region 100a may be removed and the support member including the insulating layer or the insulating material may be formed after the cell region 100a is bonded to the circuit region 200a.

In an embodiment, the gate stacking structure 120 may be stacked below the second substrate 110a so that the gate stacking structure 120 may be disposed in a structure in which the gate stacking structure 120 shown in FIG. 2 may be disposed in a vertically inverted manner. In addition, the channel structures CH that extend or pass through the gate stacking structure 120 and are sequentially stacked may have a structure in which the channel structure CH shown in FIG. 2 or FIG. 3 is disposed in a vertically inverted manner. As a result, when the channel structure CH is viewed in a cross-section, the channel structure CH may have an inclined side surface so that a width of the channel structure CH is reduced while the channel structure CH faces the second substrate 110a. Additionally, the channel pad 144 and the second wire portion 180 disposed above or on the gate stacking structure 120 may be disposed adjacent to the circuit region 200a.

For example, the first bonding structure 238 and/or the second bonding structure 194 may be made of aluminum, copper, tungsten, or an alloy including aluminum, copper, and tungsten. For example, the first and second bonding structures 238 and 194 may include copper so that the cell region 100a and the circuit region 200a may be bonded (e.g., bonded directly in contact with each other) by copper-to-copper bonding.

FIG. 13 illustrates that the gate stacking structure 120 includes three gate stacking structures 120a, 120b, and 120c, but alternatively, the gate stacking structure 120 may include two or four gate stacking structures. Except for a case described separately, the description of the gate stacking structure 120 and the channel structure CH described with reference to FIGS. 1 to 6, 7A to 7I, and 8 to 12 may be applied to FIG. 13. FIG. 13 illustrates that an electrical connection structure between the channel structure CH, the horizontal conductive layers 112 and 114, and/or the second substrate 110a is the same as that of FIG. 2. The embodiment is not limited thereto, and the electrical connection structure between the channel structure CH, the horizontal conductive layers 112 and 114, and/or the second substrate 110a may be variously modified.

The semiconductor device 10 according to an embodiment may include an input/output pad (not shown) and an input/output connection wire (not shown) electrically connected to the input/output pad. The input/output connection wire may be electrically connected to a portion of the second bonding structure 194. For example, the input/output pad may be disposed above or on an insulating layer 198b covering or overlapping an outer surface of the second substrate 110a. According to an embodiment, a separate input/output pad electrically connected to the circuit region 200a may be provided.

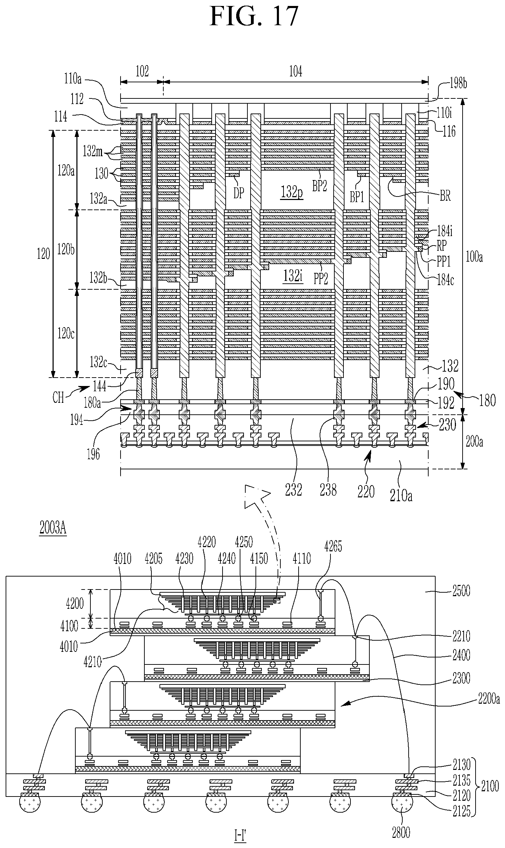

For example, the circuit region 200a and the cell region 100a may be portions corresponding to the first structure 1100F and the second structure 1100S of the semiconductor device 1100 included in the electronic system 1000 shown in FIG. 14, respectively. Alternatively, the circuit region 200a and the cell region 100a may be regions including a first structure 4100 and a second structure 4200 of the semiconductor chip 2200 shown in FIG. 17, respectively.

An example of an electronic system including the above-described semiconductor device will be described in detail below.

FIG. 14 is a view schematically illustrating the electronic system including the semiconductor device according to an embodiment.

Referring to FIG. 14, the electronic system 1000 according to the embodiment may include the semiconductor device 1100 and a controller 1200 electrically connected to the semiconductor device 1100. The electronic system 1000 may be a storage device including one or a plurality of semiconductor devices 1100 or an electronic device including the storage device. For example, the electronic system 1000 may be a solid state drive (SSD) device including one or a plurality of semiconductor devices 1100, a Universal Serial Bus (USB), a computing system, a medical device, or a communication device.

The semiconductor device 1100 may be a non-volatile memory device, and for example, may be a NAND flash memory device described with reference to FIGS. 1 to 6, 7A to 7I, and 8 to 13. The semiconductor device 1100 may include the first structure 1100F and the second structure 1100S on the first structure 1100F. In an embodiment, the first structure 1100F may be disposed next to the second structure 1100S. The first structure 1100F may be a peripheral circuit structure including the decoder circuit 1110, the page buffer 1120, and the logic circuit 1130. The second structure 1100S may be a memory cell structure including a bit line BL, a common source line CSL, a word line WL, first and second gate upper lines UL1 and UL2, first and second gate lower lines LL1 and LL2, and a memory cell string CSTR between the bit line BL and the common source line CSL.

In the second structure 1100S, each of memory cell strings CSTR may include lower transistors LT1 and LT2 adjacent to the common source line CSL, upper transistors UT1 and UT2 adjacent to the bit line BL, and a plurality of memory cell transistors MCT disposed between the lower transistors LT1 and LT2 and the upper transistors UT1 and UT2. The number of the lower transistors LT1 and LT2 and the number of the upper transistors UT1 and UT2 may be variously modified according to an embodiment.

In an embodiment, the lower transistors LT1 and LT2 may include a ground selection transistor, and the upper transistors UT1 and UT2 may include a string selection transistor. The first and second gate lower lines LL1 and LL2 may be gate electrodes of the lower transistors LT1 and LT2, respectively. The word line WL may be a gate electrode of the memory cell transistor MCT, and the gate upper lines UL1 and UL2 may be gate electrodes of the upper transistors UT1 and UT2, respectively.

The common source line CSL, the first and second gate lower lines LL1 and LL2, the word line WL, and the first and second gate upper lines UL1 and UL2 may be electrically connected to the decoder circuit 1110 through a first connection wire 1115 extending to the second structure 1100S within the first structure 1100F. The bit line BL may be electrically connected to the page buffer 1120 through a second connection wire 1125 extending to the second structure 1 100S within the first structure 1100F.

In the first structure 1100F, the decoder circuit 1110 and the page buffer 1120 may execute a control operation for at least one memory cell transistor selected from among the plurality of memory cell transistors MCT. The decoder circuit 1110 and the page buffer 1120 may be controlled by the logic circuit 1130. The semiconductor device 1100 may communicate with the controller 1200 through an input/output pad 1101 electrically connected to the logic circuit 1130. The input/output pad 1101 may be electrically connected to the logic circuit 1130 through an input/output connection wire 1135 extending to the second structure 1100S within the first structure 1100F.

The controller 1200 may include a processor 1210, a NAND controller 1220, and a host interface 1230. According to an embodiment, the electronic system 1000 may include the plurality of semiconductor devices 1100, and in this case, the controller 1200 may control the plurality of semiconductor devices 1100.

The processor 1210 may control an overall operation of the electronic system 1000 including the controller 1200. The processor 1210 may operate according to predetermined firmware, and may access the semiconductor device 1100 by controlling the NAND controller 1220. The NAND controller 1220 may include a NAND interface 1221 that processes communication with the semiconductor device 1100. A control command for controlling the semiconductor device 1100, data to be written in the memory cell transistor MCT of the semiconductor device 1100, and data to be read from the memory cell transistor MCT of the semiconductor device 1100, or the like may be transmitted through the NAND interface 1221. The host interface 1230 may provide a communication function between the electronic system 1000 and an external host. When a control command is received from the external host through the host interface 1230, the processor 1210 may control the semiconductor device 1100 in response to the control command.

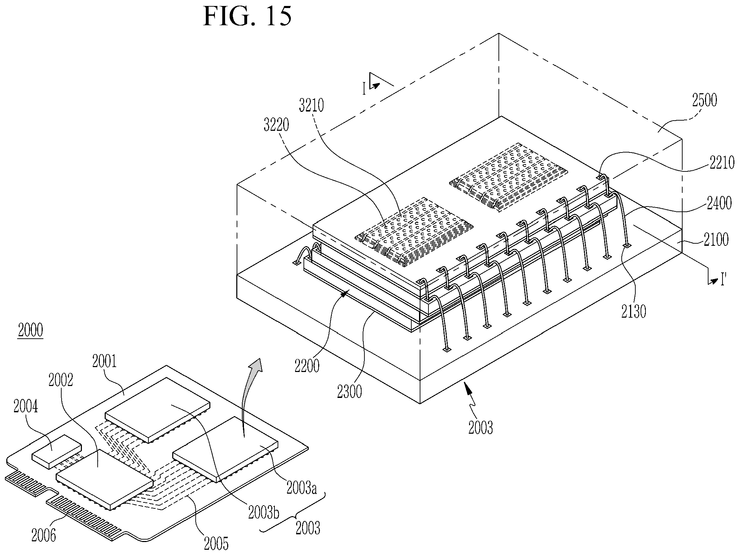

FIG. 15 is a schematic perspective view of an electronic system including the semiconductor device according to an embodiment.

Referring to FIG. 15, the electronic system 2000 according to the embodiment may include a main substrate 2001, a controller 2002 mounted on the main substrate 2001, one or more semiconductor packages 2003, and a DRAM 2004. The semiconductor package 2003 and the DRAM 2004 may be connected to the controller 2002 through a wire pattern 2005 formed at the main substrate 2001.

The main substrate 2001 may include a connector 2006 including a plurality of pins coupled to the external host. The number and an arrangement of the plurality of pins in the connector 2006 may vary depending on a communication interface between the electronic system 2000 and the external host. In an embodiment, the electronic system 2000 may communicate with the external host according to any one of interfaces such as a universal serial bus (USB), a peripheral component interconnect express (PCI-Express), a serial advanced technology attachment (SATA), an M-Phy for a universal flash storage (UFS), and the like. In an embodiment, the electronic system 2000 may operate with a power supply supplied from the external host through the connector 2006. The electronic system 2000 may further include a power management integrated circuit (PMIC) that distributes the power supply supplied from the external host to the controller 2002 and the semiconductor package 2003.

The controller 2002 may write data in the semiconductor package 2003 or may read data from the semiconductor package 2003, and may improve an operating speed of the electronic system 2000.

The DRAM 2004 may be a buffer memory for mitigating a speed difference between the semiconductor package 2003, which is a data storage space, and the external host. The DRAM 2004 included in the electronic system 2000 may also operate as a kind of cache memory, and may also provide a space for temporarily storing data in a control operation for the semiconductor package 2003. When the electronic system 2000 includes the DRAM 2004, the controller 2002 may further include a DRAM controller for controlling the DRAM 2004 in addition to the NAND controller for controlling the semiconductor package 2003.

The semiconductor package 2003 may include first and second semiconductor packages 2003a and 2003b spaced apart from each other. Each of the first and second semiconductor packages 2003a and 2003b may be a semiconductor package including a plurality of semiconductor chips 2200. Each of the first and second semiconductor packages 2003a and 2003b may include a package substrate 2100, the semiconductor chip 2200 above or on the package substrate 2100, an adhesive layer 2300 disposed at a lower surface of each semiconductor chip 2200, a connection structure 2400 electrically connecting the semiconductor chip 2200 and the package substrate 2100, and a molding layer 2500 covering the semiconductor chip 2200 and the connection structure 2400 on the package substrate 2100.

The package substrate 2100 may be a printed circuit board including a package upper pad 2130. Each semiconductor chip 2200 may include an input/output pad 2210. The input/output pad 2210 may correspond to the input/output pad 1101 of FIG. 14. Each semiconductor chip 2200 may include a gate stacking structure 3210 and a channel structure 3220. The semiconductor chip 2200 may include the semiconductor devices described with reference to FIGS. 1 to 6, 7A to 7I, and 8 to 13.

In an embodiment, the connection structure 2400 may be a bonding wire electrically connecting the input/output pad 2210 and the package upper pad 2130. Accordingly, in each of the first and second semiconductor packages 2003a and 2003b, the semiconductor chips 2200 may be electrically connected to each other using a bonding wire method, and the semiconductor chip 2200 may be electrically connected to the package upper pad 2130 of the package substrate 2100. According to an embodiment, in each of the first and second semiconductor packages 2003a and 2003b, the semiconductor chips 2200 may be electrically connected to each other by a connection structure including a through silicon via (TSV) instead of the connection structure 2400 using a bonding wire method.

In an embodiment, the controller 2002 and the semiconductor chip 2200 may be included in one package. For example, the controller 2002 and the semiconductor chip 2200 may be mounted at a separate interposer substrate that is different from the main substrate 2001, and the controller 2002 and the semiconductor chip 2200 may be connected to each other by a wire formed at the interposer substrate.

FIGS. 16 and 17 are cross-sectional views schematically illustrating semiconductor packages according to embodiments, respectively. FIGS. 16 and 17 respectively describe the embodiment of the semiconductor package 2003 of FIG. 15, and conceptually show a region obtained by cutting the semiconductor package 2003 of FIG. 15 along a line I-I'.

Referring to FIG. 16, in the semiconductor package 2003, the package substrate 2100 may be a printed circuit board. The package substrate 2100 may include a package substrate body portion 2120, the package upper pad 2130 disposed at an upper surface of the package substrate body portion 2120, a lower pad 2125 disposed at a lower surface of the package substrate body portion 2120 or exposed through the lower surface of the package substrate body portion 2120, and an internal wire 2135 electrically connecting the upper pad 2130 and the lower pad 2125 inside the package substrate body portion 2120. The upper pad 2130 may be electrically connected to the connection structure 2400. The lower pad 2125 may be connected to the wire pattern 2005 of the main substrate 2001 of the electronic system 2000 of FIG. 15 through a conductive connection portion 2800.

The semiconductor chip 2200 may include a semiconductor substrate 3010 and the first structure 3100 and the second structure 3200 sequentially stacked on the semiconductor substrate 3010. The first structure 3100 may include a peripheral circuit region including a peripheral wire 3110. The second structure 3200 may include a common source line 3205, the gate stacking structure 3210 on the common source line 3205, the channel structure 3220 and a separation structure 3230 penetrating the gate stacking structure 3210, a bit line 3240 electrically connected to the channel structure 3220, and a gate connection wire electrically connected to the word line WL of FIG. 14 of the gate stacking structure 3210.

In the semiconductor chip 2200 or the semiconductor device according to an embodiment, performance of the semiconductor chip 2200 or the semiconductor device may be improved by providing the buffer insulating portion 132p.

Each of the semiconductor chips 2200 may include a through wire 3245 that is electrically connected to the peripheral wire 3110 of the first structure 3100 and extends into the second structure 3200. The through wire 3245 may pass through the gate stacking structure 3210, and may be further disposed outside the gate stacking structure 3210. Each semiconductor chip 2200 may further include an input/output connection wire 3265 electrically connected to the peripheral wire 3110 of the first structure 3100 and extending into the second structure 3200, and the input/output pad 2210 electrically connected to the input/output connection wire 3265.

In an embodiment, in the semiconductor package 2003, the plurality of semiconductor chips 2200 may be electrically connected to each other by the connection structure 2400 having a bonding wire form. As another example, the plurality of semiconductor chips 2200 or a plurality of portions constituting the semiconductor chips 2200 may be electrically connected by a connection structure including a through silicon via (TSV).

Referring to FIG. 17, in a semiconductor package 2003A, each semiconductor chip 2200a may include a semiconductor substrate 4010, a first structure 4100 on the semiconductor substrate 4010, and the second structure 4200 bonded to the first structure 4100 by a wafer bonding method on the first structure 4100.

The first structure 4100 may include a peripheral circuit region including a peripheral wire 4110 and a first bonding structure 4150. The second structure 4200 may include a common source line 4205, a gate stacking structure 4210 between the common source line 4205 and the first structure 4100, a channel structure 4220 and a separation structure 4230 passing through the gate stacking structure 4210, and a second bonding structure 4250 electrically connected to the channel structure 4220 and the word line WL of FIG. 14 of the gate stacking structure 4210. For example, the second bonding structure 4250 may be electrically connected to the channel structure 4220 and the word line WL through a bit line 4240 electrically connected to the channel structure 4220 and the gate connection wire electrically connected to the word line WL. The first bonding structure 4150 of the first structure 4100 and the second bonding structure 4250 of the second structure 4200 may be bonded while contacting each other. For example, a portion where the first bonding structure 4150 and the second bonding structure 4250 are bonded may be formed of copper (Cu).

In the semiconductor chip 2200a or the semiconductor device according to an embodiment, performance of the semiconductor chip 2200a or the semiconductor device may be improved by providing the buffer insulating portion 132p.

Each of the semiconductor chips 2200a may further include the input/output pad 2210 and an input/output connection wire 4265 below the input/output pad 2210. The input/output connection wire 4265 may be electrically connected to a portion of the second bonding structure 4250.

In an embodiment, in the semiconductor package 2003A, the plurality of semiconductor chips 2200a may be electrically connected to each other by the connection structure 2400 having a bonding wire form. As another example, the plurality of semiconductor chips 2200a or a plurality of portions constituting the semiconductor chips 2200a may be electrically connected by a connection structure including a through silicon via (TSV).

## Claims

1. A semiconductor device comprising:
a gate stacking structure (120, 3210, 4210) that comprises a first stacking structure (120a) and a second stacking structure (120b) on the first stacking structure (120a), the first stacking structure (120a) and the second stacking structure (120b) each comprising a plurality of gate electrodes (130);
a channel structure (CH, 3220, 4220) that extends into the gate stacking structure (120, 3210, 4210); and
a plurality of gate contact portions (184) that are respectively connected to the plurality of gate electrodes (130) of a first pad area (PA1) of the first stacking structure (120a) or a second pad area (PA2) of the second stacking structure (120b);
wherein the first stacking structure (120a) comprises a buffer insulating portion (132p) that comprises a boundary portion (120p) that is adjacent to the second pad area (PA2),
wherein the buffer insulating portion (132p) comprises a first section (SS1), a second section (SS2), and an inner section (IS) that is between the first section (SS1) and the second section (SS2) in a first direction (Y),
wherein a length (L1 1, L21) of an upper portion of each of the first section (SS1) and the second section (SS2) in the first direction (Y) is greater than a length (L14, L24) of a lower portion of each of the first section (SS1) and the second section (SS2), respectively, and
wherein a first length difference between the length (L11) of the upper portion of the first section (SS1) and the length (L14) of the lower portion of the first section (SS1) is less than a second length difference between the length (L21) of the upper portion of the second section (SS2) and the length (L24) of the lower portion of the second section (SS2).

2. The semiconductor device of claim 1, wherein each of a reference length change amount in the first section (SS1) and a reference length change amount in the second section (SS2) is greater than a reference length change amount at one side of the upper section,
wherein the reference length change amount is a change amount or a difference in length in the first direction (Y) per a reference thickness, and
wherein the reference thickness is a distance between top surfaces of adjacent gate electrodes among the plurality of gate electrodes (130).

3. The semiconductor device of claim 1 or 2, wherein a length of the inner section (IS) in the first direction (Y) is less than or equal to a sum of the length of the upper portion of the first section (SS1) and the length of the upper portion of the second section (SS2).

4. The semiconductor device of claim 3, wherein a ratio of the length (L0) of the inner section (IS) to an entire length of the buffer insulating portion (132p) in the first direction (Y) is in a range of about 10% to about 50%, wherein the entire length of the buffer insulating portion (132p) comprises a sum of the length (L11) of the upper portion of the first section (SS1), the length (L21) of the upper portion of the second section (SS2), and the length (L0) of the inner section (IS).

5. The semiconductor device of any one of claims 1 to 4, wherein the first pad area (PA1) or the second pad area (PA2) comprises a pad section (PS) that connects respective ones of the plurality of gate electrodes (130) and respective ones of the plurality of gate contact portions (184),
wherein the pad section (PS) comprises an upper section (US), and
wherein each of a reference length change amount in the first section (SS1) and a reference length change amount in the second section (SS2) is greater than a reference length change amount at one side of the upper section (US),
wherein the reference length change amount is a change amount or a difference in length in the first direction (Y) per a reference thickness (SD2), and
wherein the reference thickness (SD2) is a distance between top surfaces of adjacent gate electrodes among the plurality of gate electrodes (130).

6. The semiconductor device of claim 5, wherein:
a side surface of the upper section (US) is a vertical surface perpendicular to the first direction (Y) or an inclined surface inclined to the first direction (Y), and
one of (i) a side surface or a lower surface of the first section (SS1) or (ii) a side surface or a lower surface of the second section (SS2) has a stair shape.

7. The semiconductor device of any one of claims 1 to 6, wherein:
the first section (SS1) comprises a plurality of dummy portions (DB) that are on the plurality of gate electrodes (130) and extend in the first direction (Y), and
the plurality of dummy portions (DB) have a substantially same dummy length (LD1).

8. The semiconductor device of any one of claims 1 to 7, wherein:
the second section (SS2) comprises a plurality of portions that are on the plurality of gate electrodes (130) and extend in the first direction (Y), and
the plurality of portions respectively comprise a first portion having a first bottom length (LD2) in the first direction (Y) and a second portion having a second bottom length (LD3) that extends in the first direction (Y) and is greater than the first bottom length (LD2).

9. The semiconductor device of claim 8, wherein in the second section (SS2), the first portion and the second portion are alternately provided in plural.

10. The semiconductor device of any one of claims 1 to 9, wherein a distance between the second section (SS2) and a cell array region (102) is greater than a distance between the first section (SS1) and the cell array region (102); or
wherein a distance between the first section (SS1) and a cell array region (102) is greater than a distance between the second section (SS2) and the cell array region (102).

11. The semiconductor device of any one of claims 1 to 10, wherein the buffer insulating portion (132p) has a shape corresponding to a pad insulating portion (132i) of the first pad area (PA1) or a shape that is symmetrical to the pad insulating portion (132i) of the first pad area (PA1) in the first direction (Y).

12. The semiconductor device of any one of claims 1 to 11, wherein the buffer insulating portion (132p) comprises an upper pattern at an upper portion of the first stacking structure (120a), or an extension pattern further including an upper buffer section (UB), and an upper portion of the inner section (IS), the first section (SS1), and the second section (SS2).

13. The semiconductor device of claim 12, wherein:
the buffer insulating portion (132p) includes the extension pattern,
each of a reference length change amount in the first section (SS1) and a reference length change amount in the second section (SS2) is greater than a reference length change amount at one side of the upper buffer section (UB),
wherein the reference length change amount is a change amount or a difference in length in the first direction (Y) per a reference thickness (SD2), and
the reference thickness (SD2) is a distance between top surfaces of adjacent gate electrodes among the plurality of gate electrodes (130).

14. The semiconductor device of any one of claims 1 to 13, wherein:
the buffer insulating portion (132p) has an asymmetric shape in the first direction (Y), or
the first section (SS1) and the second section (SS2) have the asymmetric shape in the first direction (Y).

15. An electronic system comprising:
a main substrate (2001);
the semiconductor device (10, 1100) according to any one of claims 1 to 14 on the main substrate; and
a controller (2002) that is connected to the semiconductor device (10, 1100) on the main substrate (2001).
